# EUROPEAN PATENT SPECIFICATION

(11) **EP 4 127 681 B1**
(45) Date of publication and mention of the grant of the patent: **18.12.2024**
(21) Application number: 21713037.6
(22) Date of filing: 23.03.2021
(51) Int. Cl.: G01N 21/78, G01N 21/84, G01N 21/77

(54) **OPTICAL MODULE**
OPTISCHES MODUL
MODULE OPTIQUE

(30) Priority: 27.03.2020 GB 202004488; 28.05.2020 GB 202007997; 19.10.2020 GB 202016564
(43) Date of publication of application: 08.02.2023
(73) Proprietor: AMS-OSRAM AG, 8141 Premstätten (AT)
(72) Inventor: CHONG CHEAH, Boon, 5656 Eindhoven (NL); FREDERIX, Filip, 5656 Eindhoven (NL); JAN LOUS, Erik, 5656 Eindhoven (NL)
(74) Representative: Tergau & Walkenhorst Intellectual Property GmbH
(86) International application number: PCT/EP2021/057405
(87) International publication number: WO 2021/191196

(56) References cited:
- EP-A1- 2 214 026
- WO-A1-2020/049066
- US-A- 5 518 689
- US-A1- 2003 161 762
- US-A1- 2005 237 531
- US-A1- 2007 081 920
- US-A1- 2014 134 072

## Description

### TECHNICAL FIELD

The present invention relates to assay reader devices, in particular to optical modules for reading a test region of an assay.

### BACKGROUND

Diseases are generally identified using one of three approaches.

The first is central laboratory analysis where a sample is collected and sent to a central laboratory for thorough analysis by expensive, large, high-throughput equipment. The second is point-of-care testing using one of a number of different technology platforms such as microfluidic-based tests where suitable specialist diagnostic equipment is available on site at e.g. a hospital. The third is point-of-care testing using lateral flow test technology.

Lateral flow technology is based on a series of capillary beds, such as pieces of porous paper, micro-structured polymer, or sintered polymer. Each of these elements has the capacity to transport fluid (e.g., urine) spontaneously. The first element (the sample pad) acts as a sponge and holds an excess of sample fluid. Once soaked, the fluid migrates to the second element (conjugate pad) in which the manufacturer has stored the so-called conjugate, a dried format of bio-active particles in a salt-sugar matrix that contains everything to guarantee an optimized chemical reaction between the target molecule (e.g., an antigen) and its chemical partner (e.g. antibody) that has been immobilized on the particle's surface. While the sample fluid dissolves the salt-sugar matrix, it also mobilizes the particles and in one combined transport action the sample and conjugate mix while flowing through the porous structure. In this way, the analyte binds to the particles while migrating further through the third capillary bed. This material has one or more regions (often called stripes or lines) where a third molecule has been immobilized by the manufacturer. By the time the sample-conjugate mix reaches these strips, analyte has been bound on the particle and the third 'capture' molecule binds the complex. After a while, when more and more fluid has passed the stripes, particles accumulate and the stripe-area changes colour. Typically, there are at least two regions:
1. One (the control) that captures any particle and thereby shows that reaction conditions and technology worked fine, typically the test line appears on the test strip before the control line
2. The second (the test) contains a specific capture molecule and only captures those particles onto which an analyte molecule has been immobilized. This makes the diagnostic result of the test visible.

After passing these reaction regions the fluid enters the final porous material, the wick, that simply acts as a waste container and also assists in controlling the flow rate. Multiple test lines can also be positioned adjacent each other with the last line on the strip being the control line.

There are generally three types of lateral flow tests.

Type 1: lateral flow tests without any electronics. A user "reads" a colour change by naked eye, giving a yes/no answer to the user. These types of lateral flow tests are not suitable for diagnostic tests where quantification is required. For the identification of many diseases, quantitative measurements are important and these yes/no, qualitative types of tests are generally not suitable for quantitative diagnostics testing.

Type 2: lateral flow tests with an external optical readout. This type allows in an increased level of quantification and an increased sensitivity. In particular, quantitative measurements typically use imaging technology (for example, fluorescence, luminescence, absorbance and/or reflection imaging) to image a test region of a lateral flow test strip to determine a quantitative value based on, in the simplest case, the strength of a colour change in the test region is. However, for this type of lateral flow test, an external reader device, for example a desktop-sized reading apparatus is required. Furthermore, an external device means that the distance between the colour change being quantified and the detector is typically large, for example of the order of greater than 5-10cm. An increased distance between the colour change being quantified and the detector results in a decreased signal strength.

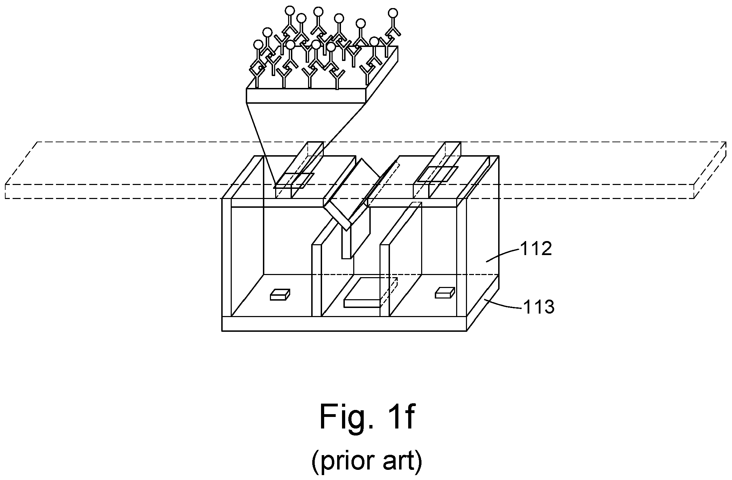

Type 3: lateral flow tests with the light source and detector assembled on, for example, a printed circuit board. An advantage of these kind of readout systems is that quantification is possible and an increased sensitivity can be achieved without the need for external detector hardware. However, this type of solution utilises discrete components such as LEDs, photodiodes and various structural components assembled by a pick and place machine. Typically, the components will be secured in position by glue and/or solder. An example of an assembly of this type is described in WO 2020/049066 A1 and illustrated in Figure 1f. A problem of such assemblies is that there may be displacement of the components in an uncontrollable way as a result of solder or glue reflow at high temperatures applied during one or more manufacturing steps. This problem may be particularly noticeable with the larger structural components such as housings that have a heavier weight relative to the other components of the assembly and are thus more susceptible to reflow misalignment. For example, translation and/or rotation of the housing 112 in Figure 1f around the printed circuit board 113 in Figure 1f they are placed on may occur in the assembly of WO 2020/049066 A1. A consequence of this unpredictable positional misalignment is that quantitative measurements provided by such assemblies are less reliable. For example, a weak detected signal from a test line may be indicative of lower analyte concentration in a sample or it may be the result of bad positional misalignment. Accordingly, such assemblies may be inaccurate and can cause unpredictable variation in quantitative measurements thereby reducing reproducibility and accuracy.

Despite the above issues, lateral flow technology is significantly cheaper and easier to scale up than the central laboratory approach and other point-of-care testing approaches in part because the raw materials, reagents and equipment it relies on are more widely available and can be mass produced more easily. Moreover, if de-centralized testing can be enabled or even be done by the patient themselves, logistics costs of transporting samples to a centralized testing facility and waiting times can be reduced.

The global Covid19 pandemic of 2020 has made it apparent that the central laboratory testing and specialist diagnostic equipment point-of-care testing approaches are unable to be scaled up fast enough to process the vast numbers of tests needed to meet the unprecedented explosion in global demand caused by the pandemic. Future pandemics are also likely to cause a similar sharp increase in demand for testing capacity which laboratory and specialist diagnostic equipment point-of-care testing approaches are unlikely to be able to meet. Additionally, to minimise the impact of a pandemic on the economy in a controlled way, determining who is and who is not immune is likely to be beneficial as those who are immune may return to work more quickly. Accordingly, immunity self tests on a massive scale may become a main tool in a government's approach to limiting the economic impact of a pandemic in a way that can be scaled up and mass-produced cheaply and quickly.

It is therefore an aim of the present disclosure to address one or more of the problems above or at least to provide a useful alternative.

### SUMMARY

The present invention is directed to an optical module for reading a test region of an assay as defined in appended independent claim 1. Particular embodiments of the invention are defined in appended dependent claims 2-13. The invention is also directed to an assay reader device as defined in appended claim 14.

In general terms, this disclosure proposes to overcome the above problems by providing an optical module, for example for a lateral flow test reader device, having imaging components integrated and/or mounted on a substrate and positionally aligned with a housing which encloses the optical module and has one or more openings through which the regions of the assay can be imaged. The housing may have a shaped surface to receive the substrate in the aligned position and/or legs to matingly engage with the substrate, thereby fixing the positional alignment of the housing and in particular the openings therein, relative to the substrate and thus also relative to the imaging components thereon such as a light source and a detector.

Unlike in a case where a housing is placed on a surface of a printed circuit board and secured with solder, glue and/or other means without support to minimise reflow induced movement (as is shown for example in Figure 1f), the shaped surface and/or legs provide for a mating engagement between the substrate and the housing. In this way, even if reflow occurs, any resulting movement of the relatively heavier housing relative to the substrate and the imaging components thereon is minimised. As a result, positional misalignment between the imaging components and the one or more openings in the housing is minimised and the accuracy and reliability of a measurement made by such a module is improved compared to, for example, the assembly described in WO 2020/049066 A1.

Accordingly, by integrating the components on a substrate which has a mating engagement with a housing that aligns the substrate, and thus the components mounted thereon, with the housing and in particular with the openings of the housing in a manner that does not suffer from reflow issues, a miniaturised, pre-calibrated optical module is provided. Such a module can be incorporated as a single unit onto a printed circuit board (that is, a printed circuit board which may optionally but need not be in addition to the substrate onto which the imaging components are mounted and/or integrated) of a lateral flow test reader device. By minimising the risk of misalignment in this way, the manufacturing variability between the optical modules according to the present disclosure is significantly reduced and, accordingly, such modules helps to provide accurate, quantitative, reproducible lateral flow test results and in a manner that is suitable for mass production at a global scale.

As described above, one reason for the above problems of lateral flow technology is that imaging components (for example, the light source and the detector) and a housing are assembled onto a printed circuit board by a pick and place machine and secured using solder and/or glue. During the rest of the manufacturing process, temperature changes cause the solder and/or glue to partially liquefy and flow. This is known as reflow and results in misalignment of the components. In addition, as a housing is likely to be one of the larger, heavier components, the reflow misalignment can be significant as the relatively heavier weight of the housing is likely to result in significant translation and/or rotation on the liquefied solder and/or glue. Thus, even where components are initially accurately placed and secured by a pick and place machine, they lose the alignment by the end of manufacturing process due to reflow issues. In such cases, the optical signal strength and quality will vary depending on how much the positional alignment has been affected by reflow - something that is difficult to control consistently and reliably.

In contrast, the present invention overcomes this problem by providing a shaped surface, for example, in or on one or more walls of the housing and/or legs extending from the housing to provide the required positional alignment and restrict subsequent relative movement. In particular, the mating engagement between the shaped surface and/or legs and the substrate minimises the amount the housing may move relative to the substrate should reflow occur, thus reducing the overall misalignment the optical module suffers from. In this way, consistent and reproducible alignment between the imaging components and the openings in the housing is achieved. The resulting optical measurements are accordingly also more consistent which means any measurement variation across batches of optical modules according to the present disclosure is reduced, making calibration easier.

According to a first aspect of the present disclosure, there is provided an optical module for reading a test region of an assay. The optical module comprises the features defined in appended independent claim 1.

Beneficially, the provision of the housing as part of the optical module and the resulting positional alignment of the optical module components this achieves ensures the optical module consistently returns reproducible results.

One or more walls of the housing may comprise a shaped surface configured to receive the substrate in a predetermined position to provide said positional alignment. Beneficially, this provides for an accurate positional alignment and/or fixing of the substrate (on which the imaging components are mounted) to the housing of the optical module (on which the one or more openings are formed). In particular, the shaped surface provides for a more accurate alignment than may be achieved when a housing is mounted on a substrate without a shaped surface to guide it into positional alignment and to minimise and/or prevent the substrate from moving for example as a result of reflow during manufacturing. The shaped surface may comprise one or more of a step, slot, and/or bevel on one or more surfaces of said walls of the housing.

The housing may comprise one or more legs extending from an outer surface of the housing, for example beyond the substrate and/or an upper and/or lower surface of the housing in a vertical direction. Where one or more of the legs extend from an outer surface of the housing below the housing, the one or more legs may be configured for mating engagement with one or more respective holes in a printed circuit board of an assay reader device to positionally align the optical module relative to the printed circuit board, For example, this may control the x/y alignment in the plane of the surface of the printed circuit board as the legs engage at the x/y positions of the respective holes and/or this may control the z alignment (i.e. how high or low the optical module is positioned in the reader device housing) as the legs engage up to the depth of the respective holes.

The printed circuit board of the assay reader device optionally being additional to the substrate on which the light source and optical detector are mounted. A reverse arrangement may be used alternatively while achieving the same technical effect, whereby one or more legs extend from a printed circuit board which can be received by holes in the housing. Where one or more of the legs extend from an outer surface of the housing above the housing, these may be configured for mating engagement with one or more respective holes, slots and/or support structures in a housing of an assay reader device to positionally align the optical module relative to the housing of the assay reader device. For example, again controlling the x,y,z alignment of the optical module in the housing of the assay reader device by serving the function of a spacer albeit integrated with the optical module housing. Similarly, a reverse arrangement may be used while achieving the same technical effect, whereby one or more legs extend from the assay reader device housing that can be received by holes in the optical module housing. Additionally and/or alternatively, a spacer may also be provided on the optical module housing to abut a matching surface or spacer on the housing of the assay reader device to further control the z alignment.

Beneficially, the one or more legs extending from the optical module housing improve the alignment of the optical module with other components of an assay reader device such as the reader housing and/or reader printed circuit board. For example, the printed circuit board of the reader device may be integral with or fixed to a reader housing or an internal support structure thereof, for example with one or more screws and thread, glue, push-fit and/or other fixing technique. Even more beneficially, using legs that extend both above and below the optical module housing ensure the optical module is simultaneously aligned with both the printed circuit board of the assay reader device and the reader device housing in all x,y,z directions.

Optionally, the one or more legs may comprise a flexible hook portion. The flexible hook portion may be configured to secure the housing to the substrate with a snap-fit engagement through one or more respective holes in the substrate thereby preventing relative movement between the substrate and the housing.

Beneficially, the snap-fit engagement provided by the flexible hook portion allows the housing to be aligned and secured without the need to use glue or for example a screw and thread that can be difficult to control and/or risks misalignment of the housing.

Optionally, the substrate may comprise a printed circuit board of an assay reader device.

Alternatively, the substrate need not be a printed circuit board of an assay reader device but may be a standalone substrate that may be positioned on such a printed circuit board, thus advantageously allowing the optical module to be manufactured and calibrated as a standalone module that can later be assembled onto a separate printed circuit board without requiring separate alignment and calibration.

Optionally, the one or more legs may further be configured for mating engagement with one or more respective holes in a housing of an assay reader device.

Beneficially, this means the legs positionally align the optical module housing not only with a printed circuit board of an assay reader device but also simultaneously with the assay reader device housing without needing to rely on other separate non-integral alignment means.

The optical module in accordance with the invention comprises one or more first baffles, for example wall-like structures, positioned on the substrate between the optical detector and the first light source to block direct propagation of light from the first light source to the optical detector.

Beneficially, blocking direct light form the light source to the optical detector reduces noise in the detected signal and an offset to the detected signal.

The optical module may comprise a blocking portion positioned in the first optical path configured to block a portion of light incident on or reflected by the test region to reduce an intensity of the light received by the optical detector. Optionally, the blocking portion may be positioned between an inside surface of the housing and the one or more first baffles to block a central portion of the optical axis of the first optical path.

The light causing the strongest specular reflections is close to the optical axis and that light is blocked. The light causing weaker specular reflections in comparison is able to reach the optical detector. The technical advantage is therefore that the signal to noise ratio is improved by preventing the optical detector becoming saturated.

The optical module in accordance with the invention comprises a second light source for illuminating a control region and/or a further test region of the assay. The second light source has a similar arrangement as the first light source in that the second light source is mounted on the substrate and the housing comprises a second opening for providing a second optical path from the second light source to the control region and/or further test region and from there to the optical detector. Similarly, the housing and the substrate further enclose and positionally align the second light source relative to the first and second openings in the housing and relative to the optical detector.

Beneficially, as in the case with the first light source, any misalignment of the housing and the openings therein relative to the imaging components and in particular any misalignment of the second light source relative to the other components is minimised as described above.

The optical module may comprise one or more second baffles positioned on an inside surface of the housing between the first and second openings to block propagation of light from the first light source to the control and/or further region and to block propagation of light from the second light source to the test region.

Beneficially, this reduces the amount of cross-talk in the detected signal. In particular, only light from one of the light sources illuminates each of the assay regions visible through the respective openings.

The first and second light sources and/or the optical detector may be encased in a transparent moulded polymer compound e.g. a thin polymer transparent film, and the first and/or second optical paths may be provided through the moulded polymer compound.

Beneficially, this protects the light sources and/or the optical detector from dust, particles, fibres and or other dirt that may enter into the housing through the openings. As the optical module comprises its own housing which together with the substrate provides an enclosed, protected space, neither the light sources nor optical detector require a separate cap (in addition to the transparent moulded polymer compound) for protection.

Beneficially, this reduces the material in the optical path that the light has to propagate through thereby reducing the amount the light is attenuated by and thereby increasing signal strength.

The first and second optical path may alternatively be direct, uninterrupted optical paths. For example, such that neither a moulded compound nor a cap encases/covers the light sources and/or optical detector.

Beneficially, this further reduces the material in the optical path that the light has to propagate through thereby reducing the amount the light is attenuated by and thereby further increasing signal strength. In particular, the presence of a cap and moulded compound reduces signal strength and thus performance by around 74%. Omitting a cap and moulded compound may thus result in a corresponding increase in signal strength and thus performance.

The dimensions of a device will depend on the size of the test strip and the test and control lines. The overall dimensions may also be adapted depending on other factors such as user requirements. For example, users with impairments may wish to use devices with a larger outer housing. Some particular dimensions are provided by way of example only. The height of the housing may be between 0.6 mm and 5.0 mm, preferably between 1.6 mm and 4.0 mm, more preferably between 2.1 mm and 3.5 mm.

Beneficially, this allows the test region of the assay being read to be positioned significantly closer to the light sources and optical detector than lateral flow readers which use non-integrated external hardware and this increase in signal strength compared to such readers. For example, a vertical distance between the optical detector and the first and/or where present the second openings may be between 0.1 mm and 4.5 mm, preferably between 1.1 mm and 3.5 mm, more preferably between 1.510 mm and 1.700 mm. In particular, by providing a low height in this manner, the distances between the optical detector of the optical module and the test strip being measured are reduced when compared to known devices and thus provide a higher signal strength.

A length of the first and/or second opening may be between 2.5 mm and 6.5 mm, preferably 5 mm, and a width of the first and/or where present the second opening may be between 0.5 and 1.5 mm, preferably between 0.850 mm and 1.050 mm.

Beneficially, these dimensions reduce the amount of background, ambient light entering the openings and thus reduce noise.

The optical module may comprise a transparent material positioned over the first and/or where present the second openings.

Beneficially, this prevents dust, dirt, fibres and/or other particles from entering the space enclosed by the housing thereby protecting the components and preventing unwanted noise from such particles in the optical paths inside the housing. Further, the transparent material may provide a seal between the space enclosed by the housing and the substrate and the space outside thereof. The seal enhances protection and may also make the optical module water resistant by preventing moisture entering the enclosed space.

A portion of the housing may comprise a transparent material having an opaque material on a surface thereof, and the first and/or the second openings may comprise gaps in the opaque material.

Beneficially, this allows the openings to be inherently sealed to prevent dust, dirt, fibres and/or other particles from entering the space enclosed by the housing.

The transparent material referred to above may comprise glass or plastic foil and/or a transparent filler material at least partially filling space enclosed by the module. The housing may preferentially comprise a matt black material.

The optical module may comprise an electrical signal processor, electrically coupled to the electrical output of the optical detector to process the electrical signal output by the optical detector. The electrical signal processor may be mounted on the substrate such that the electrical coupling is provided by one or more electrical connections on and/or integrated with the substrate, or it may be provided separately whereby the electrical coupling is provided by, for example, one or more wire bonds, contacts or other electrical connections through the substrate to, for example, a printed circuit board of an assay reader device.

The first light source, the optical detector and the second light source and/or where present the electrical signal processor may be provided adjacent to one another in a first planar arrangement, wherein the first and where second the openings may be provided in a second planar arrangement parallel to and facing the first planar arrangement.

Beneficially, this arrangement enables the imaging components to be mounted on the substrate in a manner that permits the first and where present the second optical paths to be provided without mirrors and/or other optical components.

The optical module may comprise a plurality of optical detectors and electrical signal processors and/or a third light source arranged to illuminate a plurality of test regions of the assay. The third light source where present may have an arrangement similar to or corresponding to the first and second light sources as is described above.

Beneficially, this allows multiple test regions to read simultaneously.

According to a second aspect of the present disclosure, there is provided an assay reader device comprising the optical module described above. The assay reader device comprises: a reader housing; and a printed circuit board positioned inside the reader housing. The printed circuit board comprises one or more first holes for receiving a portion of the housing of the optical module therein to positionally align said optical module relative to the reader housing. The reader housing comprises one or more second holes for receiving a portion of the housing of the optical module therein to positionally align the optical module relative to the reader housing.

Beneficially, this provides an assay reader device providing the above described advantages of the optical module.

The substrate of the optical module may comprise the printed circuit board of the assay reader device. The portion of the housing received in the first holes of the printed circuit board or the second holes of the reader housing may be the legs of the optical module. Beneficially, this allows the assay, for example the test and/or control regions thereof to be accurately aligned with the opening in the housing of the optical module in the assay reader device to ensure an accurate, consistent and reproducible test result.

The assay reader device may be configured to receive a test strip of a lateral flow test therein, and the reader housing may comprise one or more spacers arranged on an inside surface of the reader housing facing the first and/or second openings in the housing of the optical module. The one or more spacers are arranged to receive the test strip thereon. The housing may also comprise one or more biasing arms arranged on an inside surface of the reader housing and being configured to apply a force to one or more ends of the test strip to tension the test strip over the one or more spacers to positionally align the test strip relative to the optical module. For example, by controlling the z position alignment (i.e. height above the optical module at which the test strip is held in place).

Beneficially, tensioning the test strip over the spacers by applying a force to one or more ends of the test strip (i.e. thereby keeping it taut over the spacers) allows for the accurate control of the height at which the test/control regions on the test strip are positioned relative to the optical module. This in turn ensures a consistent and accurate reading of the test strip. In contrast, where a test strip is not held taut and the height of the test regions varies, the accuracy and consistency of the reading may vary.

According to a third aspect of the present disclosure, there is provided a method of manufacturing the optical module described above. The method comprises: mounting a first light source and an optical detector comprising an optical input and an electrical output on a substrate; with the substrate and a housing, enclosing the first light source and the optical detector; and positionially aligning the first light source and the optical detector relative to a first opening of the housing by positioning the substrate on a shaped surface of one or more walls of the housing and/or engaging legs of the housing with corresponding holes or slots in the substrate, the shaped surface being configured to receive the substrate in a predetermined position to provide said positional alignment. Beneficially, this method ensures the housing, the substrate and the components mounted on the substrate are positionally aligned and/or fixed relative to each other and in particular relative to the openings in the housing in a way that is more accurate than for example simply gluing the housing to a surface of the substrate. The shaped surface may optionally comprise one or more of a step, slot, and/or bevel on one or more surfaces of said walls of the housing. If the optical module comprises a second and/or further light sources and the housing comprises a second and/or further openings as described with reference to the optical module described above, the positionally aligning step also aligns the second and/or further light sources relative to the second and/or further openings in the housing to provide the advantages as described above.

### BRIEF DESCRIPTION OF THE DRAWINGS

These and other aspects of the present disclosure will now be described by way of example only, with reference to the accompanying drawings.
Figure 1a shows a first view of an optical module according to the present disclosure.
Figure 1b shows a cross-sectional view of the optical module of Figure 1a.
Figure 1c shows an alternative cross-sectional view of the optical module of Figure 1a.
Figure 1d shows a top view of the optical module of Figure 1a.
Figure 1e shows a cross-sectional view of the optical module of Figure 1a having different dimensions.
Figure 1f shows a known optical module.
Figure 2a shows a cross-sectional view of an optical module according to the present disclosure.
Figure 2b shows a cross-sectional view of a portion of a housing of an optical module according to the present disclosure.
Figure 3 shows a cross-sectional view of an optical module according to the present disclosure.
Figure 4 shows a cross-sectional view of an optical module according to the present disclosure.
Figure 5 shows an exploded view of a substrate and optical detector and electrical signal processor according to the present disclosure.
Figure 6 shows a top view of an optical module according to the present disclosure.
Figure 7 shows a top view of an optical module according to the present disclosure.
Figure 7a shows an illustrative top view of an optical module according to the present disclosure.
Figure 8a shows a cross-sectional view of an optical module according to the present disclosure.
Figure 8b shows a cross-sectional view of an optical module according to the present disclosure.
Figure 9 shows a cross-sectional view of an optical module according to the present disclosure.
Figure 10 shows an assay reader device according to the present disclosure.
Figure 11a shows an assay reader device according to the present disclosure.
Figure 11b shows an assay reader device according to the present disclosure.
Figure 12a shows an assay reader device according to the present disclosure.
Figure 12b shows an assay reader device according to the present disclosure.
Figure 13a shows an assay reader device according to the present disclosure.
Figure 13b shows an assay reader device according to the present disclosure.
Figure 14a shows an assay reader device according to the present disclosure.
Figure 14b shows an assay reader device according to the present disclosure.
Figures 15a-15c illustratively show assembly stages of an assay reader device according to the present disclosure.
Figure 15d shows a cross section view of the assembled assay deader device of Figures 15a-15c.
Figure 15e illustratively shows a cross sectional view of an assay reader device housing according to the present disclosure.
Figure 16 is a flowchart of a method according to the present disclosure.
Figure 17 illustratively shows a layout of a spectral sensor according to the present disclosure.
Figure 18 illustratively shows a functional block diagram of a spectral sensor and electrical signal processor circuitry according to the present disclosure.
Figure 19 illustratively shows a functional block diagram of a spectral sensor and electrical signal processor circuitry according to the present disclosure.
Figure 20a shows a top view of an optical module according to the present disclosure.
Figure 20b shows a cross-sectional view of the optical module of Figure 20a.
Figure 21 shows a cross-sectional view of an optical module according to the present disclosure.
Figure 22a is a vertical cross section of an optical module.
Figure 22b is a top view of an optical module.
Figure 23a is a vertical cross section through an optical module.
Figure 23b is a vertical cross section through an optical module.
Figures 24 a to d are views of components of an optical module in different stages of assembly.

### DETAILED DESCRIPTION

As described above, the present disclosure provides an optical module, for example for a lateral flow test reader device, having imaging components integrated on a substrate and positionally aligned with a housing which encloses the optical module and has one or more openings through which the regions of the assay can be imaged. By integrating the components on a substrate and aligning the substrate, and thus the components mounted thereon, with the housing and in particular with the one more openings of the housing, a miniaturised, pre-calibrated optical module is provided. Such a module can be incorporated as a single unit onto a printed circuit board of a lateral flow test reader device without the need to separately, manually align all the components during assembly of the lateral flow test reader device. The shaped surface according to the present disclosure ensures that any movement of the housing relative to the substrate of the optical module itself (e.g. caused by reflow) is minimised. Such a module thus helps to provide accurate, quantitative, reproducible lateral flow test results and is suitable for mass production at a global scale.

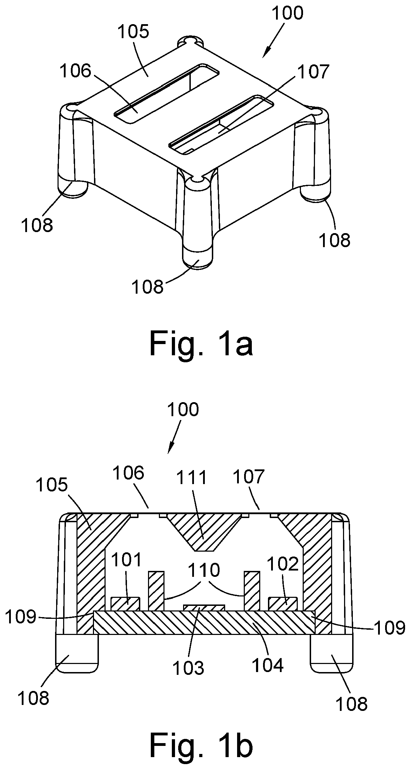

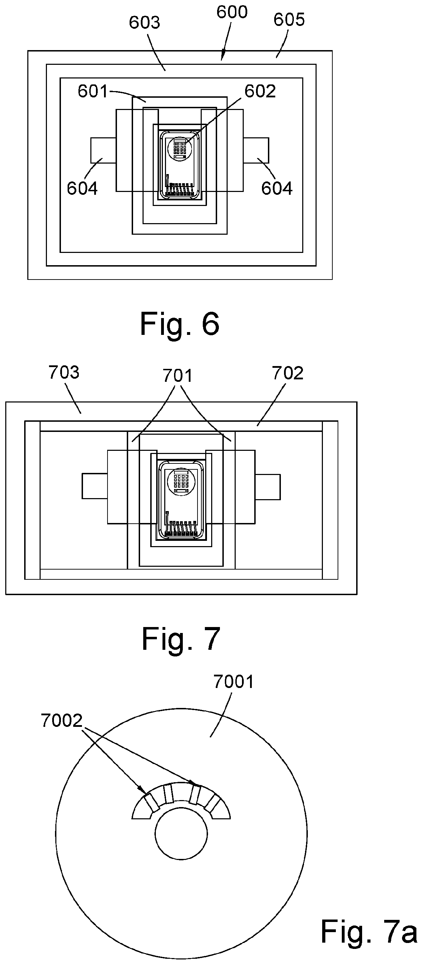

Figure 1a shows a first view of an optical module 100 for reading a test region of an assay (not shown) according to the present disclosure. Figure 1b shows a cross-sectional view of the optical module 100 of Figure 1a. As described above, the optical module 100 comprises a first light source 101 for illuminating a test region of the assay. The optical module of Figure 1a is also shown to comprise a second light source 102 for illuminating a control region of the assay. The optical module further comprises an optical detector 103. The optical detector 103 comprises an optical input for receiving light emitted from the test region and the control region of the assay. The optical module optionally further comprises an electrical signal processor, electrically coupled to the electrical output of the optical detector 103. Alternatively, the electrical signal processor may be separate from the optical module, for example as part of an assay reader device into which the optical module is incorporated. If the electrical signal processor forms part of the optical module, the optical detector 103 may be mounted on the electrical signal processor to optimise space usage and the electrical signal processor may comprise for example an application-specific integrated circuit, one or more dies, and/or any other microchip designed for processing the output signal of the optical detector 103. The optical module 100 comprises a substrate 104 for mounting the first and second light sources 101, 102, the optical detector 103, and the electrical signal processor. The substrate 104 may be a printed circuit board (PCB) (that is, a standalone PCB that may be provided in addition to any PCB of an assay reader device into which the optical module is incorporated as will be described below, or it may be integral with and a portion of the PCB of the assay reader device itself). The substrate 104 may be bonded to the light sources 101, 102, the optical detector 103, and/or if present the electrical signal processor with wire bonding, soldering and/or metalized contact pads. The optical module 100 comprises a housing 105. The housing 105 comprises a first opening 106 for providing a first optical path from the first light source 101 to the test region of the assay and from the test region to the optical detector 103. The housing 105 shown in Figure 1a further comprises a second opening 107 a second light source 102 represent and for providing a second optical path from the second light source 102 to the control region of the assay and from the control region to the optical detector 103. The housing 105 and the substrate 104 enclose and positionally align and/or fix the first and second light sources 101, 102, the optical detector 103, and where present the electrical signal processor relative to the first and second openings 106, 107. The housing 105 is shown to have a generally square shape to match a generally square shape of the substrate 104. However, both the housing 105 and the substrate 104 and any components mounted thereon may have other shapes. For example, the substrate 104 may have a round disk-like shape whereby the components mounted thereon are arranged around the centre of the disk-like shape. Such an arrangement is shown in Figure 7a where the housing 105 has a round, circular-like shape to match the substrate. The housing 105 in the example of Figures 1a-1d and in all the other Figures described herein may be moulded, for example injection moulded, 3D printed and/or a combination thereof. Moulding the housing provides for manufacturing tolerances (i.e. how accurately a designed value can be achieved) of around 50 µm. 3D printing provides for manufacturing tolerances higher than this. Accordingly, the amount of movement of the housing 105 relative to the substrate caused by e.g. reflow during manufacturing and thus the extent of any positional misalignment is determined by how well the substrate fits into the shaped surface of the housing 105. This may thus be determined by the tolerances of the manufacturing techniques used. Accordingly, the present disclosure provides for optical modules where positional misalignment is around 50-250 µm or less.

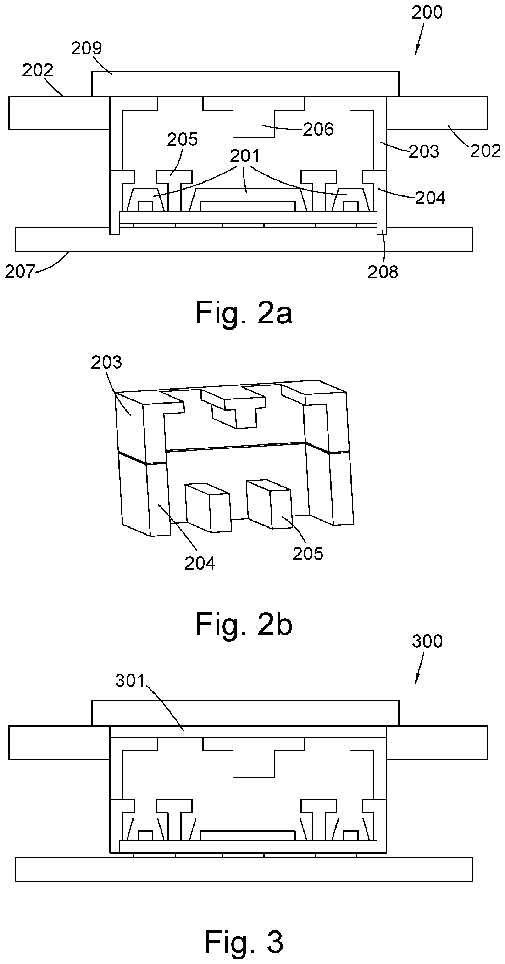

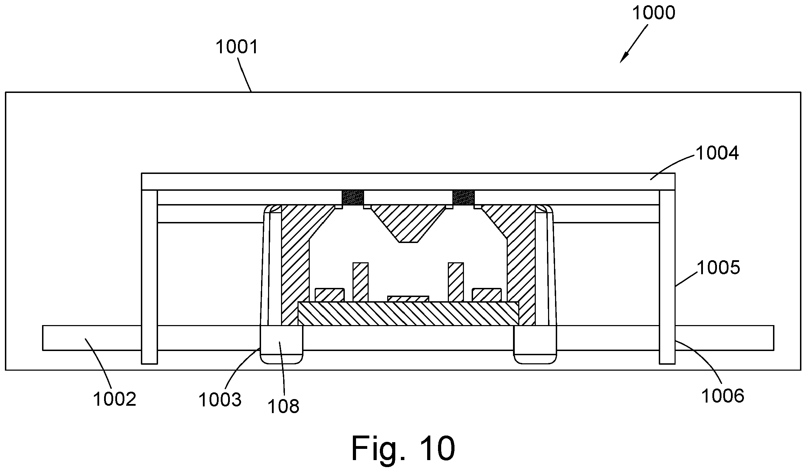

The housing 105 may comprise one or more legs 108, for example four legs, extending from an outer surface of the housing 105 beyond the substrate 104 in a vertical and/or horizontal direction. Where the housing has one or more corners, the legs 108 may be positioned at the corners of the housing 105. Where the housing is round without corners, the legs 108 may be positioned towards an edge of the housing, or through a central portion of the housing and through the substrate 104 to provide the extension in e.g. a vertical direction beyond the substrate 104. The one or more legs 108 may be configured for mating into engagement with one or more respective holes in a printed circuit board of an assay reader device (described below with reference to Figures 10-15d ) to positionally align the optical module 100 relative to the printed circuit board of the assay reader device. The legs 108 may be secured in the holes of the printed circuit board of the assay reader device with, for example, screw and thread, glue, push-fit and/or other fixing technique. The legs described above are not shown in the examples of Figures 2-9 however it is envisaged that they may be present and thus provide the above described advantages.

One or more walls of the housing 105 may comprise a shaped surface 109 configured to receive the substrate 104 in a predetermined position to provide the positional alignment in an accurate and fixed manner. By accurately controlling the shaped surface 109 during manufacturing, for example by controlling manufacturing tolerances of a 3D printing and/or moulding technique used to manufacture the housing 105 as described above, the position of the substrate 104 and the components mounted thereon relative to the housing 105 and in particular relative to the openings 106, 107 can be controlled and any relative movement minimised. In particular, the position in or on which the substrate fits onto the shaped surface can be predetermined to coincide with the optimal alignment of the light sources 101, 102, the optical detector 103 and the openings 106, 107 to maximise the strength of the measured signal. This predetermined position may be estimated using known simulation techniques. Any deviation from this position that would have arisen from reflow movement is minimised as a result of the shaped surface 109.

The shaped surface may comprise one or more of a step, slot and/or bevel on one or more surfaces of the walls of the housing 105. In the example visible in Figure 1b, the shape is a step in the wall of the housing 105.

As described above, the optical module 100 comprises one or more first baffles 110, for example a wall-like structure, positioned on the substrate 104 between the optical detector 103 and the first and second light sources 101, 102. The one or more first baffles 110 block the direct propagation of light from the first and second light sources 101, 102 to the optical detector to reduce noise from, for example, saturating the optical detector 103 with direct light source light. The one or more first baffles 110 may have any suitable shape or profile, for example a rectangular, rounded, V-shaped, or a T-shaped profile. The optical module 100 may also comprise one or more second baffles 111 positioned on an inside surface of the housing 105 between the first and second openings 106, 107. The one or more second baffles 111 minimise cross-talk by ensuring only light from the first light source 101 propagates through the first opening and only light from the second light source 102 propagates through the second opening. The one or more second baffles 110 may have any suitable shape or profile, for example a rectangular, rounded, asymmetric, V-shaped, or a T-shaped profile. In other words, cavities which are not directly in the optical path are filled up with material to reduce light pollution. The material is molding material, for example, and the actual shape can be optimised depending on the design parameters. The mold material is preferably matte black to absorb as much light as possible.

The internal surfaces of the walls of the housing 105 may also have an internal shape structure, for example sloped edges and/or corners, to maximise illumination of the applicable test or control region.

In the example shown in Figure 1b, the shapes and sizes of the first and second baffles 110, 111 and the internal shape of the housing 105 are optimised to maximise the signal strength while reducing noise and cross-talk. The optimal shape of the first and second baffles and the internal surfaces may be estimated through simulation. In particular, the first and second baffles may be shaped so as to provide a maximum signal-to-noise ratio at the detector and reduce unwanted reflections, for example by having an oblique shape with a sloped surface. The slope may be configured to face a direction, for example towards the respective light source, to maximise reflection of any direct light source light away from the sensor without significantly affecting light that reflects from the assay test/control regions. The example of Figure 1b, the second baffle 111 has a sloped surface facing towards the first light source 101 but which is roughly parallel to the light path from the first opening to the optical detector. In this way, the amount of light from the first light source that might otherwise have reflected from the second baffle 111 directly on to the optical detector 103 is reduced but the light propagating from the first opening 106 to the optical detector 103 is largely unaffected. The same is true in relation to the second light source 102 and the second opening 107. These sloped-like and other shapes may be determined through known 3-dimensional numerical simulation techniques, for example using ray-tracing techniques and verified during known testing and design verification procedures.

As described above, the first and second light sources 101, 102, the electrical signal processor and/or the optical detector 103 may optionally be encased in a protective moulded polymer compound and the optical paths are provided through the moulded polymer compound which attenuates the signal strength. Alternatively, signal strength may be improved by omitting the moulded polymer compound entirely. Instead, protection of the components is achieved with the housing 105 and the enclosing of the components by the positioning of the substrate onto the shaped surface of the housing. In the example where no protective compound or cap is present, the first and second optical paths are direct, uninterrupted optical paths.

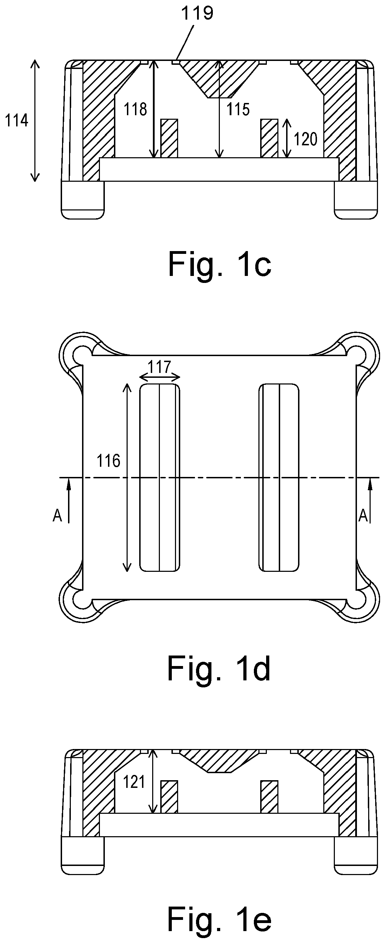

Figures 1c and 1d illustratively provide example dimensions of features of the housing 105 in millimetres where Figure 1c is a cross sectional view through the line A-A in Figure 1d. The functional features shown in Figure 1b such as the optical detector 103 and light sources 101, 102 are not shown in Figures 1c and 1d for ease of viewing although it is envisaged they are present. For example, the height of the housing 105 may be between 1.5 mm and 5.0 mm, preferably between 2.5 mm and 4.0 mm, more preferably between 3.0 mm and 3.5 mm. For example, in Figure 1c, the housing is shown to have a height of 3.120mm (denoted by line 114) excluding the additional extent of the legs. Similarly, the vertical distance (denoted by line 115) between the optical detector 103 and the first and/or second opening may be between 1.0 mm and 4.5 mm, preferably between 2.0 mm and 3.5 mm, for example 2.5mm. When manufacturing tolerances are taken into account, this may be preferably be between 2.410 mm and 2.600 mm. Further, the length of the first and/or second opening (denoted by the line 116) may be between 2.5 mm and 6.5 mm, preferably 5 mm, and wherein a width of the first and/or second opening (denoted by the line 117) is between 0.5 and 1.5 mm, for example 1mm. When manufacturing tolerances are taken into account, this may be between 0.850 mm and 1.050 mm.

The positional alignment of the components mounted on the substrate 104 and the openings in the housing 105 may be manufactured to one or more predetermined manufacturing tolerances as described above. Example manufacturing tolerances of some of the measurements provided in Figure 1c are provided as follows. The distance between the optical detector 103 and either of the light sources 101, 102 may have a tolerance of +/- 150 µm. The distance 115 from optical detector 103 to either of the openings 106,107 may have a tolerance of +/- 250 µm. The distance 118a from either of the openings 106, 107 to its corresponding light source 101, 102 may have a tolerance of +/- 150 µm. The width 117 of the openings 106, 107 may have a tolerance of +50/- 150 µm. The height 119 of the portion of the housing 105 through which the openings 106, 107 are provided may have a tolerance of +150/-90µm. The height 120 of the one or more first or second baffles may have a tolerance of +/-115 µm. The above tolerances are given by way of example only and the same advantages described herein may also be achieved with other tolerances.

Figure 1e shows alternative dimensions of the housing of Figure 1c in mm. In particular, the vertical distance 121 between the optical detector and the first and/or second openings may be around 1.6mm. This alternative design may otherwise have the same features and the advantages they provide as the other optical modules described herein and may be manufactured with the same tolerances as described above with reference to Figure 1c and 1d.

Figure 2a shows a cross-sectional view of an optical module 200 according to the present disclosure. The optical module 200 of Figure 2a has the same features as those shown in Figures 1a-1d except as follows. Identical features are not labelled separately for improved readability. Firstly, a mould compound 201 is shown encasing the first and second light sources. Secondly, the shaped surface in the wall of the housing with which positional alignment may be achieved and the legs are not shown. These may be provided, for example in a different plane to the view provided by Figure 2a. The housing may comprise a single integral portion or separate 3D printed or injection moulded parts 203, 204 (for example shown in Figure 2b) which may be glued together. The one or more first baffles 205 have a T-shaped profile (not shown in Figure 2b) and the one or more second baffles 206 have a square-shaped profile. The optical module 200 is positioned on a printed circuit board 207 of an assay reader device which may have one or more additional structural components 202 as will be described herein later with reference to Figures 10-15d. Further, the shaped surface in the wall of the housing that provides the alignment between the substrate and the housing may also have a vertical extent 208 beyond the substrate such that it extends beyond the outer surface of the substrate. This may be useful in ensuring further alignment with, for example, the printed circuit board 207 of an assay reader device. This may be instead of or in addition to the legs 108 as is described above with reference to Figures 1a-1e. In particular, the legs 108 may be one or more shapes of the shaped surface. Figure 2a also shows a specimen 209 such as a test strip of an assay being presented to the one or more openings of the housing.

Figure 3 shows a cross-sectional view of an optical module 300 according to the present disclosure. The optical module 300 has the same features as shown in Figure 2a except as follows. Identical features are not labelled again for simplicity. The optical module 300 comprises a transparent material 301 positioned over the first and/or second openings. The transparent material 301 prevents dirt, dust, fibres or other particles from getting into the housing. The transparent material 301 may provide a seal between a space enclosed by the housing and the substrate and a space outside thereof. The transparent material may comprise, for example, glass or a transparent plastic foil. The shaped surface of the walls of the housing that provides the alignment between the substrate that the housing in the example of Figure 3 does not have a vertical extent beyond the outer of surface of the substrate although it is envisaged as an option if required.

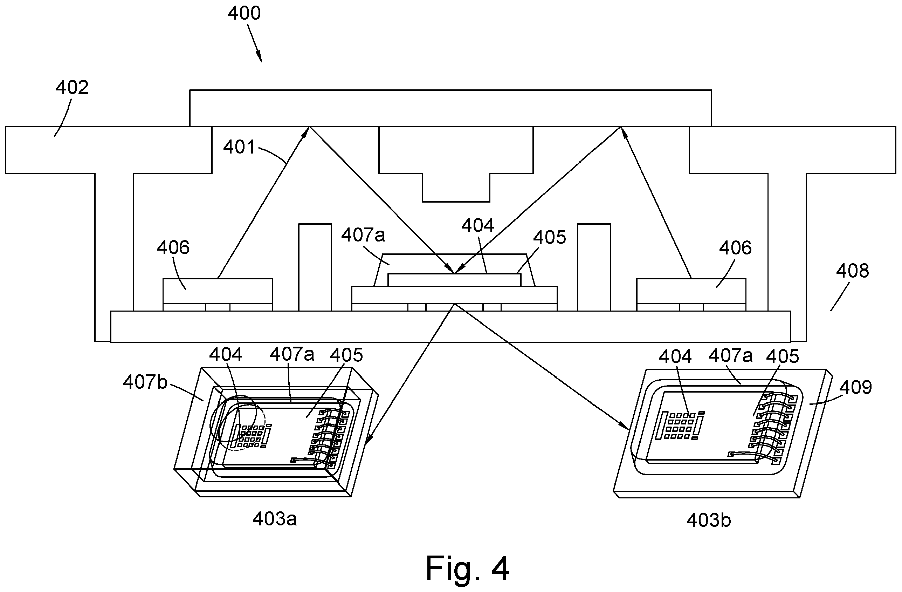

Figure 4 shows a cross-sectional view of an optical module 400 according to the present disclosure. The optical module 400 may have any of the same features as the optical modules shown in Figures 1a-1d, 2 and 3 and described with reference thereto. Identical features are not labelled separately for improved readability. Figure 4 illustratively shows an optical path 401 between the first light source(s), through the first opening in the housing, onto a test region of an assay where light is reflected back to the optical detector. The housing may comprise the legs, shown as one or more alignment structures 402 in Figure 4, to assist in positionally aligning the optical module 400 with a printed circuit board or other structure of an assay reader device as will be described herein later with reference to Figures 10-15d. This is a similar arrangement to what is shown in Figures 2-3. The light sources 406 are not encased in a protective moulding compound in the example shown in Figure 4. Different encasing options of the optical detector 404 and the electrical signal processor 405 if present are shown in Figure 4. The electrical signal processor 405 may itself comprise a substrate 409 in addition to the substrate 408 with which the housing of the optical module 400 is enclosed however this is optional and depends on the requirements of the electrical signal processor 405. In one option 403a, a cap 407b and a protective moulding compound 407a are provided. In a second option 403b, only the protective moulding compound 407a is provided. It is also envisaged that neither the cap 407b nor the moulding compound 407a is provided to improve signal strength as described above.

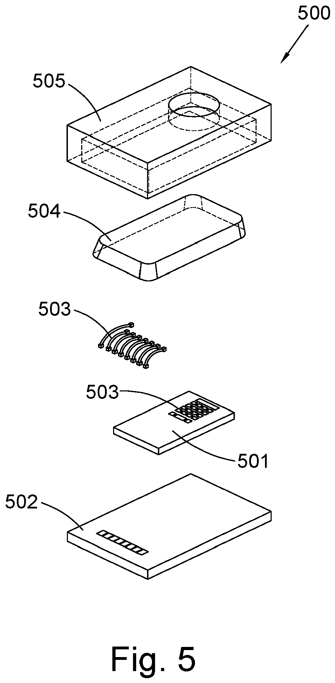

Figure 5 shows an exploded view of an arrangement having an electrical signal processor 501 having its own substrate 502 (separate and in addition to any substrate of an optical module and/or a substrate of an assay reader device neither of which are shown in Figure 5) and an optical detector 503, in this case integrated with the electrical signal processor 501, according to the present disclosure. The arrangement may be used with any of the optical modules described with reference to Figures 1-4. The moulding compound 504 and the cap 505 may be omitted to improve signal strength. The optical detector 503 and electrical signal processor 501 may be fixed to the each other and to the electrical signal processor substrate 502 with glue and electrically coupled using one or more bonding wires 503, for example 8 bonding wires depending on the number of connections required by the ASIC used.

Figures 6 and 7 show top views of variants of any of the optical modules described herein, for example which may be used together with any of the features of Figures 1-5. In Figure 6, an optical module 600 is shown where the one or more first baffles 601 are provided as a ring-like structure around the optical detector 602 and electrical signal processor. In this example, the optical detector 602 and electrical signal processor are shown to have the features of and layout illustrated by the example in Figure 4 including a protective transparent moulding compound and a separate substrate for the electrical signal processor however these are optional. The top of the housing 603 is shown as being transparent for ease of viewing the interior components including the light sources 604 but it is envisaged that the housing is opaque. In Figure 7, where corresponding features are not labelled for ease of viewing, the one or more second baffle is provided as elongate structures 701 between two walls of the housing 702.

In both Figures 6 and 7, the substrate 605, 703 with which the housing 603, 702 is respectively enclosed has a lateral extent beyond the outside of the housing 603, 702. To provide for this, the substrate 605, 703 may have one or more holes and/or indents therein to provide a matching fit with the corresponding shaped surface of the walls of the housing 603, 702. This may be beneficial in the case where the substrate 605 serves the double purpose of being a printed circuit board of an assay reader device where this is not separately provided as will be described below with reference to Figures 10-15d. This lateral extent of the substrate is not separately shown in the other figures but it is envisaged that it may be present.

As indicated above, Figure 7a provides a variant of any of the optical modules described herein in which the substrate 7001 may have a round disk-like shape whereby the components 7002 mounted thereon are arranged around the centre of the disk-like shape. The housing in this case (not shown) would have walls with a correspondingly shaped surface into which the substrate may be fitted as described above. As described above, other shapes are also envisaged.

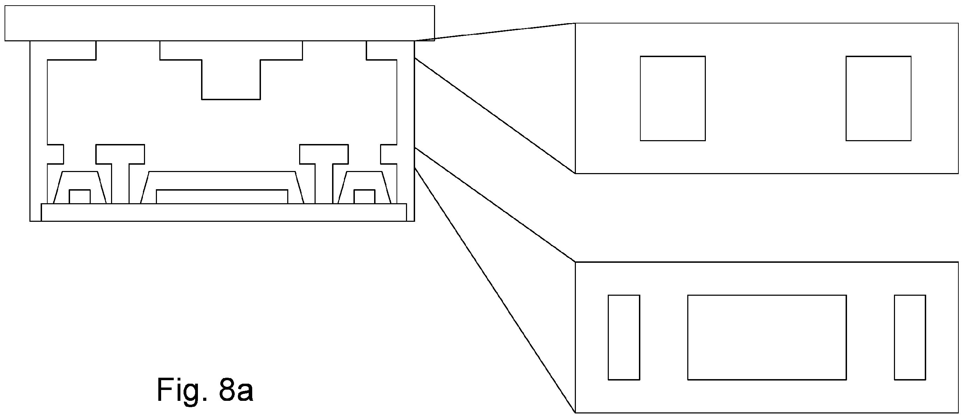

Figure 8a shows a cross-sectional view of an optical module according to the present disclosure which has the same features as the optical module shown in Figure 2a. Identical features are not labelled separately for improved readability. The top view of the first and second openings and an exemplary shape of the one or more first baffles are shown enlarged in Figure 8a. As is apparent from the top view of the baffles they have a structure similar to Figure 7 in that they are provided as elongate structures between walls of the housing.

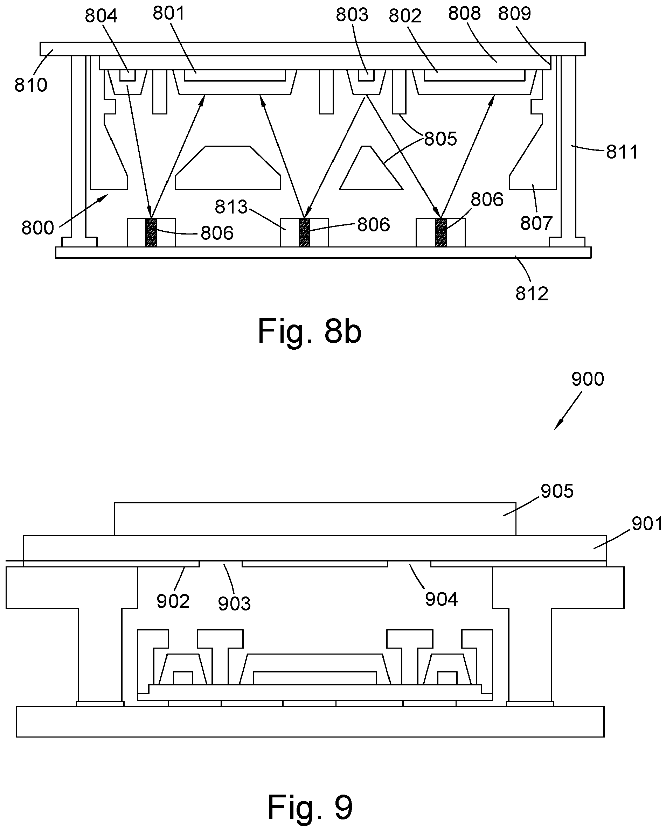

Figure 8b shows a cross-sectional view on an optical module 800 according to the present disclosure similar to those described above. The optical module shown in Figure 8b is shown in an inverted view with optical detectors 801, 802 arranged along the top of the figure. The optical module 800 in Figure 8b comprises an additional optical detector 802, an optional additional electrical signal processor and may optionally include one or more additional light sources (not shown) which may be in addition to the one or more light sources 803, 804 such as those described above with reference to Figures 1 to 8a. This allows more than a single test line and a single control line to be imaged simultaneously. It is envisaged that the optical module may be extended further in this way with any additional number of light sources and optical detectors to match a chosen number of additional test and/or control lines 806 depending on design requirements. Additional baffles 805 as described herein with reference to the Figures 1-8a may also be provided to avoid leakage of direct light from the light sources onto the optical detectors and/or to maximise signal-to-noise ratio as described above. With the additional baffles 805, one of the light sources may be used to illuminate multiple of the test and/or control lines 806. In the example of Figure 8b, one light source 803 is arranged to illuminate two of the control and/or test lines 806. Accordingly, any of the preceding optical modules may comprise a plurality of optical detectors, electrical signal processors and/or a third or more light sources arranged to illuminate a plurality of test and/or control regions of the assay.

As described above, and in accordance with the present disclosure, the example of Figure 8b is provided with a housing 807 with a number of openings therein to provide the optical paths to/from the test and/or control lines being imaged. The number of openings corresponds to the number of test or control regions being imaged, in this case three but other numbers are also envisaged. The housing 807 may be in accordance with the housing described with reference to any of the above described Figures 1-8a and thus together with a substrate 808 encloses the imaging components of the optical module 800. One or more walls of the housing 807 are thus also provided with a shaped surface 809 to retain the substrate in a predetermined aligned position to minimise any reflow misalignment. As will be described below with reference to Figures 10-15d, the optical module 800 may be mounted on a printed circuit board 810 of, for example, an assay test reader device and may be positioned adjacent to one or more support structures 811 of the assay test reader device. The support structures 811 being configured for holding a lateral flow test strip 812 or paper on which the test and/or control regions 806 are provided. The support structures 811 may optionally be provided with one or more mirrors to modify the one or more optical paths to/from the optical detectors 801, 802, light sources 803, 804 and test and/or control lines 806 depending on the design requirements of the assay test reader device.

The example of Figure 8b is provided with an optional transparent moulded polymer compound as is described above with reference to Figures 4 and 5. Those parts of the device which are in the optical path are preferably provided transparent in the relevant wavelength range, while parts which are not in the optical path are preferably matte black.

Figure 9 shows cross-sectional view of an optical module according to the present disclosure. The optical module 900 of Figure 9 has the same features as those shown in Figures 1a-1d except as follows. Identical features are not labelled again for simplicity. Firstly, a portion 901 of the optical module 900 may comprise a transparent material having an opaque material 902 on a surface thereof. This portion may form part of the housing itself or may be provided separately as is shown in Figure 9. The openings 903, 904 in the housing may comprise gaps in the opaque material where the transparent material forms part of the housing, or may be gaps arranged in the optical pathways of the optical module. The transparent material may comprise, for example, glass or a transparent plastic foil and the opaque material may comprise black ink. Figure 9 also shows a specimen 905, for example a test strip of an assay, being provided on top of the transparent material.

Figure 10 shows an assay reader device 1000 according to the present disclosure. The assay reader device 1000 comprises any of the optical modules described herein with reference to Figures 1-9. Identical features are not labelled again for clarity. The assay reader device 1000 comprises a reader housing 1001. If the assay reader device is a reusable device where the assay test strip may be used and replaced by a new one without the whole device being disposed, the device may have a slot (not shown) for removing the used assay and inserting a new one. The reader housing 1001 is illustratively shown as having a rectangular shape but may have any shape depending on design requirements as will be appreciated by the skilled person. The assay reader 1000 further comprises a printed circuit board 1002 positioned inside the reader housing 1001 The printed circuit board 1002 comprises one or more first holes 1003 for receiving the one or more legs 108 if present of the housing of the optical module to positionally align the optical module relative to the reader housing 1001. As the printed circuit board 1002 is typically spatially fixed relative to where the assay strip is positioned in the reader, this alignment ensures the optical module is aligned with the assay strip, and in particular the control and test lines thereon. Optionally, the assay reader device 1000 may comprise one or more additional support structures or legs 1005 and/or a cartridge 1004 into which the assay test strip is incorporated. The support structures or legs 1005 (for example similar to the structures 811 shown in Figure 8b) may be arranged in a mating arrangement with a corresponding one or more second holes 1006 in the printed circuit board 1002 of the assay reader device. If the assay reader device is a reusable device, it is envisaged that the cartridge 1004 is replaceable through the above described slot of the reader device 1000. If the device is a disposable device and the assay test strip is incorporated into the device at manufacture, the assay test strip may be positioned and fixed with the support structures without the need for a cartridge 1004 that is removable. In this way both the optical module, its components and its housing and the openings therein, and the assay held by the support structures or in the cartridge are reliably and consistently aligned with each other to provide accurate and reproducible quantitative readings of the assay.

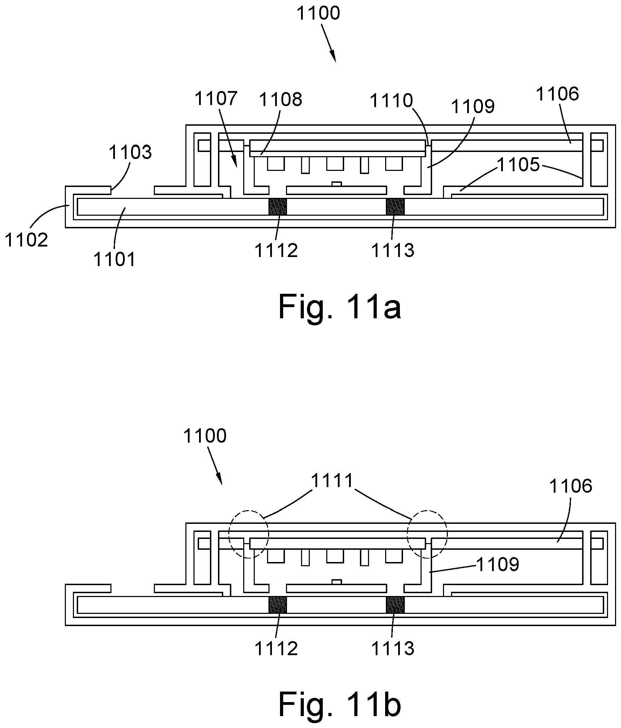

Figure 11a illustratively shows an assay reader device 1100 according to the present disclosure. The assay reader device 1100 may have some or all of the same features as described with reference to any of Figures 1-10. The components of the assay reader are shown in an inverted configuration in that the optical imaging components are facing downwards relative to a number of the arrangements of Figures 1-10 but it will be appreciated that the difference in this configuration does not affect the advantages provided by these features.

The assay reader device 1100 of Figure 11a is provided as a disposable assay reader device in that an assay test strip 1101 having a test region 1112 and control region 1113 is incorporated into a reader housing 1102. The reader housing 1102 comprises an opening 1103 therein into which a user may deposit a sample, for example blood, mucus or other sample being tested. The reader housing, which may be formed for example using injection moulding and/or 3D printing techniques, further comprises a plurality of internal support structures 1105 by which a printed circuit board 1106 of the assay reader device 1100 and the assay test strip 1001 are retained in a fixed position in the assay reader device 1102. In the case of the printed circuit board 1106, this may be achieved by providing one or more holes through the printed circuit board 1106 into which one or more of the support structures 1105 may be inserted.

The assay reader device 1100 of Figure 11a is further provided with an optical module 1107 such as an optical module as is described herein with reference to any of Figures 1-10. The optical module 1107 in the example of Figure 11a is similar to that described in Figures 1a-1b in that it comprises a substrate 1108 onto which the imaging components such as the light source and optical detector are mounted and a housing 1109. The substrate 1108 encloses and positionally aligns the light source(s) and the optical detector relative to the opening(s) in the housing 1109 and thus provides the same advantages as is provided by the optical module of Figures 1a-1b. Similarly, the housing 1109 comprises legs 1110 which matingly engage with one or more holes or indents in the printed circuit board 1106. In this way, the optical module 1107 as a whole may be positionally aligned with and mounted to the printed circuit board 1106 of the assay reader device 1100. The optical module 1107 may further be fixed in its aligned position using glue and/or solder. In a similar manner to how the shaped surface of the optical module housing 1109 walls prevents misalignment by reflow of the substrate 1108 relative to the optical module housing 1109, the mating engagement of the legs 1110 with the one or more holes or indents in the printed circuit board 1106 ensures any misalignment of the optical module 1107 as a whole relative to the reader housing 1102 is minimised.

The substrate 1108 and the components thereon may be electrically coupled to the printed circuit board 1106 for example by solder, metalized contact pads and/or wire bonds. In this way, the signals may be sent to/from the optical module as will be appreciated by the skilled person.

Figure 11b illustratively shows an assay reader device according to the present disclosure which is identical to the assay reader device 1100 of Figure 11a except that the printed circuit board 1106 of the assay reader device performs the role of and replaces the substrate which is present in Figure 11a. Only relevant features are labelled in Figure 11b for ease of viewing. In the example of Figure 11b, the optical components are mounted directly onto the printed circuit board 1106 of the assay reader device 1100 without an intervening substrate or laminate. The housing 1109 may then be fixed into its aligned position using, for example, glue and/or solder. As is apparent from regions 1111 highlighted by dashed circles, the shaped surface of the optical module housing 1109 walls engages directly with the printed circuit board 1106. This ensures any misalignment of the housing 1109 relative to the components mounted on the printed circuit board 1106 that might otherwise be caused by reflow is thus minimised. Reflow movement of the relatively heavier and bulkier housing typically being more of a problem than that of the lighter individual optical components. The legs 1110 may also be provided for mating engagement with one or more holes or indents in the printed circuit board 1106 in the same way as is described relative to Figure 11a. The printed circuit board 1106 thus performs the function of the substrate of Figure 11a in that it encloses and positionally aligns the imaging components relative to the housing. Described in another way, it may be said that the substrate which is one and the same as the printed circuit board 1106 of the reader device 1100 has a lateral extent beyond the walls of the optical module housing 1109 as is shown for example in Figures 6 and 7.

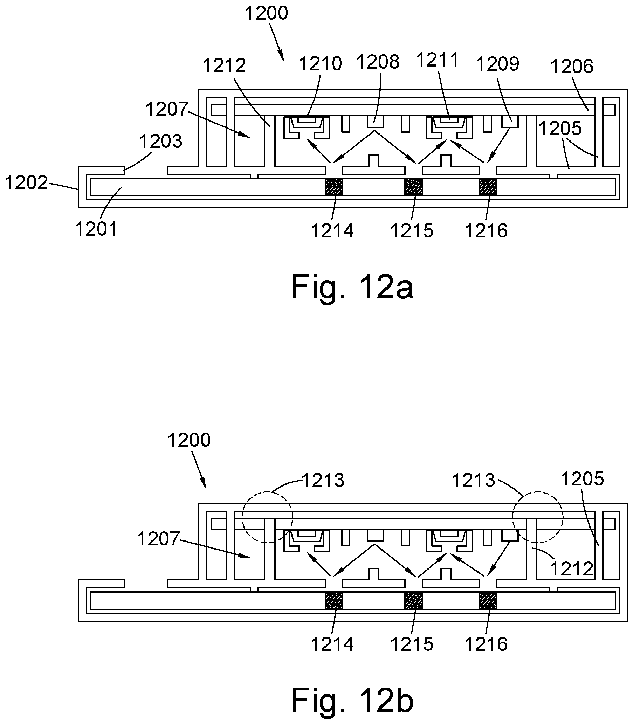

Figure 12a illustratively shows an assay reader device 1200 according to the present disclosure. The assay reader device 1200 may have some or all of the same features as described with reference to any of Figures 1-10. The assay reader device 1200 of Figure 12a is provided as a disposable assay reader device in the same way as that of Figure 11a. In particular, an assay test strip 1201 having two test regions 1214, 1215, and a control region 1216 is incorporated into a reader housing 1202 which has an opening 1203 therein into which a user may deposit a sample. Support structures 1205 may also be provided in the same way as in Figure 11a which may be used to mount a printed circuit board 1206 and the test strip 1201 in the reader device 1200.

Unlike in Figure 11a, the assay reader device 1200 of Figure 12a provides for multiple test regions 1214, 1215 in addition to a control region 1216. In order to provide for this, the optical module 1207 has a similar configuration to that described with reference to Figure 8b in that a plurality of light sources and optical detectors are provided to illuminate the plurality of test and/or control regions of the assay test strip 1201. In the example of Figure 12a, two light sources 1208, 1209 and two optical detectors 1210, 1211 are provided but other numbers are also envisaged depending on the number of regions being imaged. In Figure 12a, an optional protective transparent moulding compound is provided to cover the optical detectors 1210, 1211 as is described with reference to Figures 4 and 5 above. Additional electrical signal processors may also be provided, for example one for each additional optical detector and/or the optical detectors may be mounted on these additional electrical signal processors to save space as is described with reference to Figures 4 and 5.

Further, unlike in Figures 11a and 11b, the walls of the housing 1212 of the optical module 1207 are integral with the support structures 1205 of the reader housing 1202 which means that no separate shaped surface of the walls of the housing 1212 of the optical module 1207 or separate legs are required to provide the above described alignment. This is because, as was the case with Figure 11b, the printed circuit board 1206 performs the function of the substrate of Figure 11a in enclosing and positionally aligning the imaging components relative to the openings in the housing (which is integral with the support structures 1205 of the assay reader device 1200). As the printed circuit board 1206 is fixed to the support structures 1205 which are in turn integral and thus positionally fixed relative to the housing, reflow induced movement of the housing 1212 and any misalignment that might otherwise have resulted therefrom does not occur.

Figure 12b illustratively shows an assay reader device 1200 according to the present disclosure which is identical to the assay reader device 1100 of Figure 11a except that the housing 1212 of the optical module 1207 is also provided with legs and/or a shaped surface (not shown), indicated by dashed circles 1213, such as those described above with reference to, for example, Figures 1-10. An advantage of also providing legs 1213 even where the housing 1212 is integral with the reader housing support structures 1205 is that it provides additional structural stability of the alignment of the imaging components relative to the openings in the housing 1212. In particular, if the fixing of the printed circuit board 1206 to the support structures 1205 is not secured properly, the legs and/or shaped surface 1213 of the housing 1212 provide a failsafe to further minimise the risk of misalignment.

In both the examples of Figures 12a and 12b, the optical detectors are each provided with their own electrical signal processors to process the signal output by the respective optical detectors on chip. An advantage of this is that it provides for a fully digital solution that does not require external processing or additional conversion of an analogue signal to a digital signal and thus also permits the optical sensor to be a spectral sensor capable of performing both reflectance and fluorescence measurements depending on the capabilities of the ASIC, one or more dies, and/or any other microchip that makes up the electrical signal processor.

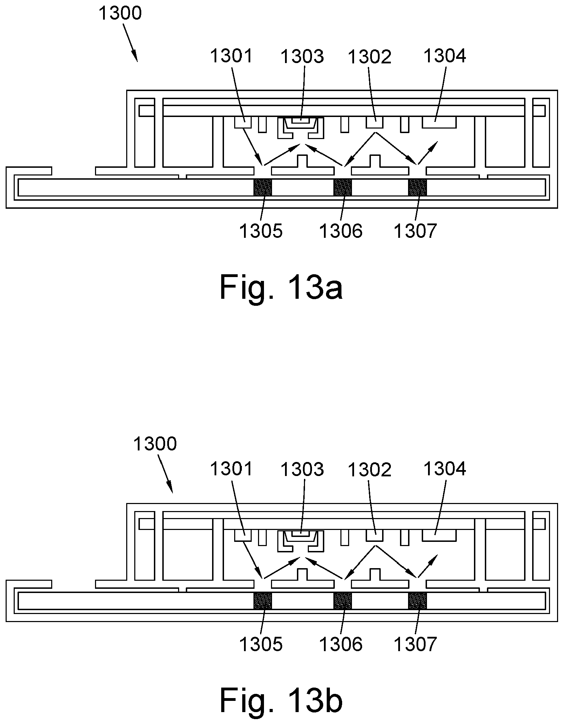

Figures 13a and 13b respectively illustrate assay reader devices 1300 according to the present disclosure which are identical to those illustrated in Figures 12a and 12b (and thus may have any of the features described herein with reference to Figures 1-12b that may be applicable to Figures 12a and 12b) except that one of the optical detectors is a photodiode without its own electrical signal processor. Further, the position of the imaging components is rearranged such that the optical detector with an electrical signal processor on chip is positioned in the optical pathways of light from both test regions 1305, 1306 to ensure both reflectance and fluorescence measurements and the additional on chip signal processing these require are still enabled. Conversely, the optical detector without its own electrical signal processor is arranged in only the optical pathway of light from the control region 1307. The control region 1307 typically does not require the significant additional on chip signal processing that signals from the test regions do. Accordingly, such an arrangement is advantageous in that it reduces monetary cost of the device because an optical detector without an electrical signal processor providing on chip processing capabilities is cheaper than an optical detector with such an electrical signal processor. However, in some cases, such an arrangement may be more difficult to adapt to fluorescence measurements and/or measurements where the control region does require additional on chip signal processing.

As is illustrated in both Figures 13a and 13b, the assay reader device 1300 comprises two light sources 1301, 1302 positioned on either side of a first optical detector 1303 mounted with and electrical signal processor suitable for both reflectance and fluorescence measurements. A second optical detector 1304 such as a photodiode without on chip signal processing capability is also provided on an opposite side of a light source 1302 to the first optical detector 1303 and arranged in the optical pathway of light from a control region.

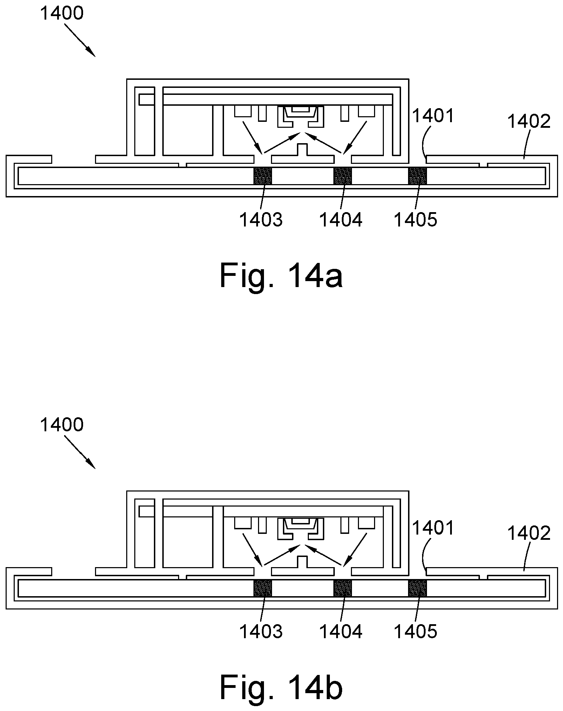

Figures 14a and 14b respectively illustrate assay reader devices 1400 according to the present disclosure which are identical to those illustrated in Figures 13a and 13b (and thus may have any of the features described herein with reference to Figures 1-13b that may be applicable to Figures 13a and 13b) except that the second optical detector arranged in the optical pathway of light from the control region 1405 is omitted entirely. Instead, a window or opening 1401 is provided in the reader housing 1402 through which the control region 1405 may be viewed by eye to confirm whether or not the assay has worked correctly. The test regions 1403, 1404 are still imaged by an optical detector. This arrangement has fewer optical imaging components than the arrangement of Figures 13a and 13b and is thus cheaper to produce. However, as the control region 1405 is illuminated only by ambient light and is read manually by eye, the assay reader device 1400 is not a fully digital solution. Further, as there is an additional opening in the housing, the ambient light may leak through the device and reduce the accuracy of the test region 1403, 1404 measurements. It is envisaged that the arrangement of Figures 14a and 14b with a window for a control region 1405 instead of an optical detector may also be applied to arrangements where there is only one test region instead of two.

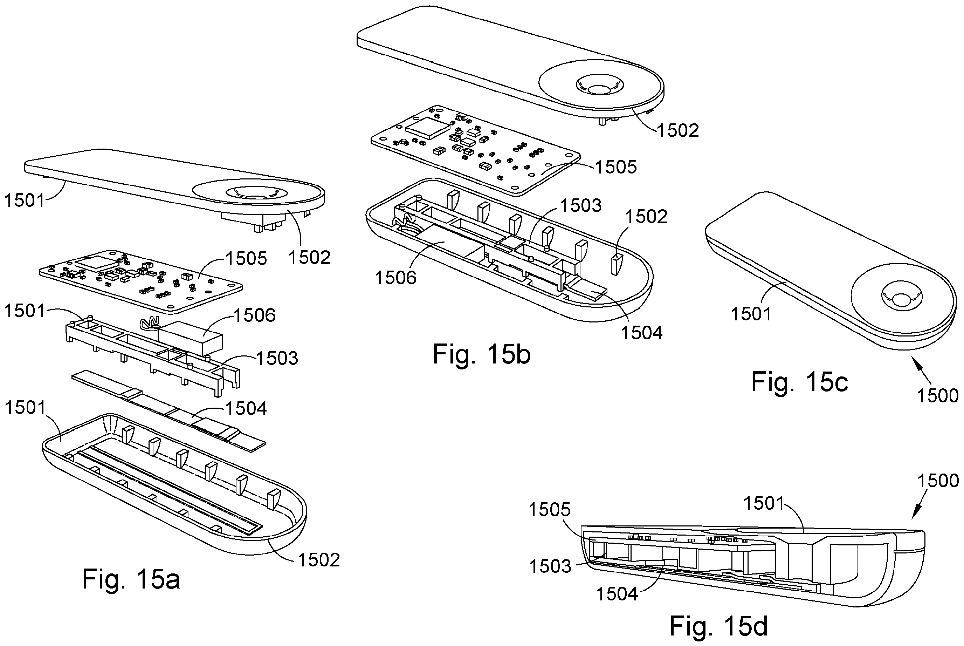

Figures 15a, 15b, 15c illustratively show various views of stages of assembly of an assay reader device according to the present disclosure. Figures 15a-15c are illustrative only and it is envisaged that any of the assay reader devices and/or optical modules described herein with reference to Figures 1-14b may be assembled as illustrated in Figures 15a-15c. Figure 15d illustratively shows a cross section view of the assembled assay reader device shown in Figure 15c. As described above an assay reader housing 1501 may comprise a plurality of component parts including an outer shell 1502 (made up of one or more parts) and internal support structures 1503 that may be, for example, injection moulded or 3D printed parts. These may be fixed to each other using one or more known techniques such as glue, push-fit, screw/thread and/or other known methods. An assay test strip 1504, printed circuit board 1505 and power supply such as a battery 1506 are also provided. The internal support structures 1503 and/or corresponding structures on the inside of the outer shell 1502 are shaped to house the internal reader device components in their respective positions inside the housing 1501. As described above with reference to Figures 1-14b, an optical module may be secured to the printed circuit board 1505 of the assay reader device 1500. The optical module may be the stand alone module with its own separate housing and substrate as is described for example with reference to Figures 1-11a, or the housing and/or substrate may be integral with and/or form part of the reader housing and printed circuit board as is described for example with reference to Figures 12a-14d. Mounted on the printed circuit board 1505 may also components to enable communications with an external device. For example, Bluetooth^{®}, Wi-Fi^{™}, USB and/or other wired and/or wireless communications components may be mounted on the printed circuit board in order to provide a network interface to communicate a result of the assay test to an external device, such as a mobile device, computer, cloud servers and the like. The printed circuit board may have its own processor mounted thereon which is in addition to the electrical signal processors described above.

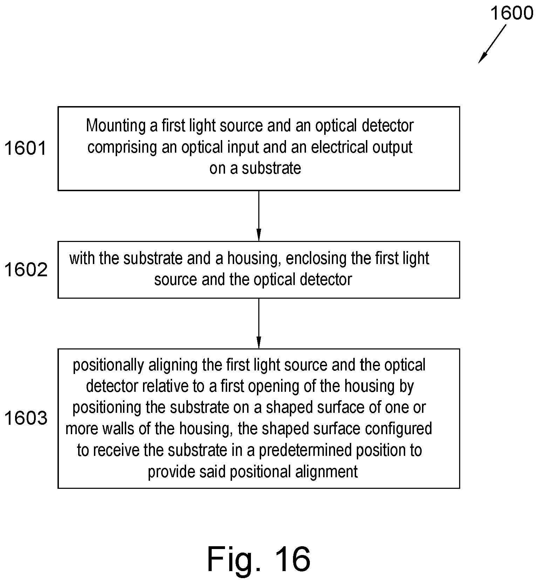

Figure 16 is a flowchart of a method 1600 according to the present disclosure. The method comprises, mounting 1601 a first light source and an optical detector comprising an optical input and an electrical output on a substrate. The method 1600 further comprises, with the substrate and a housing, enclosing 1602 the first sources, the optical detector and the electrical signal processor, and 1603 positionally aligning the first light source and the optical detector relative to a first opening of the housing by positioning the substrate on a shaped surface of one or more walls of the housing and/or engaging legs of the housing with respective holes, slots, or indents in the substrate, the shaped surface configured to receive the substrate in a predetermined position to provide said positional alignment. As described above, aligning the substrate with the housing in this way is more accurate than mounting the housing on the substrate without a shaped surface and/or legs configured for providing the aligned position.

The method of Figure 16 may be performed by existing pick-and-place machines typically used on printed circuit board assembly lines thereby being particularly suitable for mass-production without requiring significant modification of existing assembly lines. In particular, pick-and-place machines, also known as surface mount technology component placement systems are used for high precision placing of electronic components onto PCBs. The pick-and-place machine may comprise one or more robotic arms, actuators and control system for placing the components of the optical module onto each other as required. The above described tolerances and the advantages they provide of improved alignment of the components of the optical module may be achieved by using such pick-and-place machines to mount the first and second light sources, the optical detector and an optional electrical signal processor on the substrate, and to bring the housing and its openings into their aligned position with the substrate to enclose the components of the optical module. Additional manufacturing steps may include, for example, attaching the light sources, optical detector and/or electrical signal processor with a thin glue (of a few microns) to the substrate and wire bonding these to the substrate from the side. When the optical module is ultimately assembled onto a PCB of an assay reader device, as a surface mounted device, the alignment will be based on where the test strip is intended to be positioned in/on the device according to which the shaped surface and/or legs of the optical module are designed. The mounting of the light sources, optical detector and/or electrical signal processor onto each other and/or the substrate may comprise aligning electrical contacts on the bottom thereof and/or gluing and/or soldering these to each other (the glue is shown in some figures as a thin line of material between the components). The glue and/or solder may be around 100microns thick and solder reflow with temperature may cause x, y, and z displacement during tilting of the components. This is typically one source of less accurate manufacturing tolerances so the structural latching of the substrate to the housing and/or other structural alignment features described herein ensure such displacement is minimised and/or reduced.

The present disclosure describes in isolation each individual feature described herein and any combination of two or more such features, to the extent that such features or combinations are capable of being carried out based on the specification as a whole in the light of the common general knowledge of a person skilled in the art, irrespective of whether such features or combinations of features solve any problems disclosed herein, and without limitation to the scope of the claims. It is envisaged that aspects of the disclosure may consist of any such individual feature or combination of features. In view of the foregoing description it will be evident to a person skilled in the art that various modifications may be made within the scope of the disclosure. However, any combination of features or embodiment in accordance with the present invention must at least comprise the combination of features defined in appended independent claim 1.

The skilled person will understand that in the preceding description and appended claims, positional terms such as 'above', 'along', 'side', etc. are made with reference to conceptual illustrations, such as those shown in the appended drawings. These terms are used for ease of reference but are not intended to be of limiting nature. These terms are therefore to be understood as referring to an object when in an orientation as shown in the accompanying drawings.

Although the disclosure has been described in terms of embodiments as set forth above, it should be understood that these embodiments are illustrative only and that the claims are not limited to those embodiments. Those skilled in the art will be able to make modifications and alternatives in view of the disclosure, which are contemplated as falling within the scope of the appended claims. Within the scope defined by the claims, each feature disclosed or illustrated in the present specification may be incorporated in any embodiments, whether alone or in any appropriate combination with any other feature disclosed or illustrated herein.

For example, the optical detector of any of the optical modules described above may comprise one spectral sensor and two white LEDs. The spectral sensor may have a cap and moulded compound encasing it. In this case, the cap and moulded compound reduce performance (e.g. signal-to-noise ratio) by around 74%. Therefore, to improve performance by around 74%, the cap and moulded compound may be removed. Further, in any of the above optical modules, the light sources, the optical detector and/or electrical signal processor may be fixed to the substrate with glue and may be electrically coupled to the substrate with one or more wire bonds or couplings.

Further, in all of the above examples, the first and second light sources, the optical detector, and where present the electrical signal processor are provided adjacent to one another in a first planar arrangement whereas the first and second openings are provided in a second planar arrangement parallel to and facing the first planar arrangement. However, other arrangements are also envisaged, for example where the light sources are in a different plane to the optical detector.

As will be appreciated, the present disclosure may be used with any type of lateral flow test assay including fluorescence and reflection measurements at any wavelength of light and for any single or multi-analyte test. The improved alignment achieved with the present disclosure enhances signal strength and thus improves sensitivity of any quantitative measurements made.

As will be appreciated, the assay reader device referred to herein may be a disposable assay reader device, for example where the device has only one use. Alternatively, it may be a re-useable reader device where the cartridge is removed, the used assay replaced with a new one and the cartridge reinserted into the device.

As will be appreciated, many different assay tests may be used with the present disclosure. For example, test regions may be provided for to test for the presence of immunoglobulins IgG, IgM and/or IgA in a test sample, as will be known to the skilled person.

As will be appreciated, both the optical module housing and the assay device reader housing, support structures and other structural components may be produced using for example injection moulding and/or 3D printing techniques and/or may be provided as a kit of parts for assembly into a final product. Such assembly may include fixing component parts to each other using glue, screws/thread, push-fit and/or other fixing techniques known to the skilled person.

Further, it will be appreciated that a printed circuit board and any holes therein may be manufactured in high volume to a highly accurate manufacturing tolerance of +/- 5 µm. Accordingly, when the optical module and its components and openings are aligned to the tolerances described herein, its positional alignment relative to the printed circuit board of an assay reader device may achieve significantly higher levels of alignment accuracy than may be achieved with for example manual, workshop alignment methods.

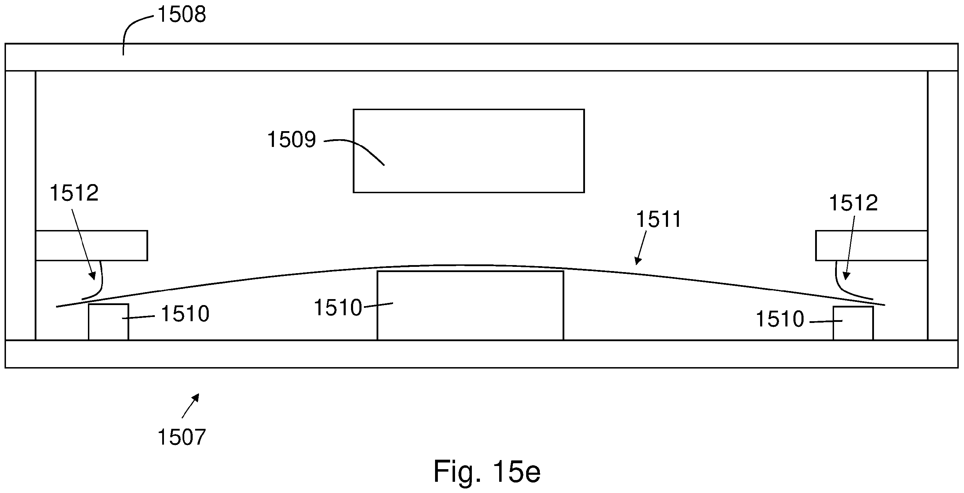

Further, as is shown illustratively in Figure 15e, it is envisaged that the reader housing described herein (for example the reader housing described in connection with any of Figures 10-15d) may be provided with one or more spacers and one or more biasing arms arranged on an inside surface of the reader housing. Figure 15e illustratively shows a cross sectional view of an assay reader device 1507 housing 1508 according to the present disclosure in which the optical module 1509 according to the present disclosure is provided. The one or more spacers 1510 are envisaged to face the first and/or second openings on the optical module 1509 housing and the test strip 1511 of a lateral flow test may be received on the spacers 1510 with the test/control regions facing the optical module 1509. The one or more biasing arms 1512 are arranged at one or more ends of the test strip 1511 and apply a force to the ends of the test strip 1511 to push or pull it taut over the spacers 1510. In this way, the test strip 1511 is retained under tension in a positionally aligned manner and the risk of misalignment caused by the test strip 1511 moving in the reader housing 1508 is minimised. The height of the spacers 1510 controls how close to the optical module 1509 and test strip 1511 are positioned to each other and may be set during manufacture of the reader housing 1508. The biasing arms 1512 may comprise for example flexible plastic or metal and the tension may be applied for example when the reader device 1507 is assembled/snapped together causing the test strip 1511 to be pushed against the biasing arms 1512, thereby deforming them and inducing a restorative force in the biasing arms 1512 that keeps the test strip 1511 taut and pulled over the one or more spacers 1510.

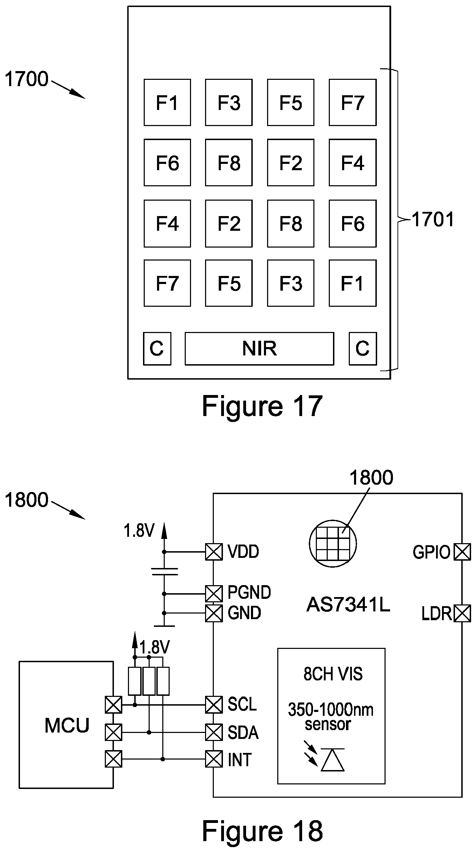

As described above, the optical detector of any of the optical modules described herein may comprise a spectral sensor. Spectral sensors provide the ability to detect and distinguish a plurality of colour changes in a single test region, for example associated with the presence of a corresponding plurality of analytes by providing plurality of output channels corresponding to different portions of the electromagnetic spectrum. The example optical detectors 404, 503 illustrated in Figures 4 and 5 are shown to comprise a spectral sensor and it is envisaged that such a sensor may be used in any of the embodiments described herein, particularly when multiple signals of different wavelengths originating from the same test region are to be detected and distinguished simultaneously. Further details of a spectral sensor to be used in connection with any of the embodiments described herein will now be described with reference to Figures 17-19.

Figure 17 illustratively shows a layout of an exemplary spectral sensor 1700 according to the present disclosure that may be used in connection with any of Figures 1-16. The spectral sensor 1700 comprises an array 1701 of photodiodes each having a corresponding colour filter F1, F2, F3, F4, F5, F6, F7, F8, C, NIR provided in front thereof thereby controlling what wavelength of light is received by each photodiode. One or more photodiodes may also be provided with a clear filter C or no filter at all to allow all wavelengths to reach the corresponding photodiode. One or more of the photodiodes may also be provided with a near infrared (NIR) filter. The example array 1701 in Figure 17 comprises a 4x4 array of photodiodes and filters arranged in pairs so that at least two photodiodes are provided in each colour channel to provide redundancy in case one of the two photodiodes fails. Two photodiodes immediately adjacent the 4x4 array 1701 (but still forming part of the spectral sensor) are provided with a clear filter, for example to provide a reference signal against which the colour changes detected by the other photodiodes may be calibrated or compared. One or more photodiodes are also provided with the NIR filter for detecting any infrared colour changes in the test region. In the example spectral sensor 1700 of Figure 17, ten channels are provided corresponding to the following approximate spectral bands: F1 (350-440nm), F2 (415-475nm), F3 (445-515nm), F4 (475-555nm), F5 (515-595nm), F6 (550-630nm), F7(580-680nm), F8 (630-730nm), C (390-1000nm), NIR (850-1000nm). At least some of the bands may overlap with each other and it is envisaged that any suitable arrangement of photodiodes and colour filters may be used to control the spectral sensitivity of the sensor to different wavelengths depending on the colour changes in assay test regions that the spectral sensor 1700 is being used to detect. For example, the pairwise arrangement of Figure 17 that provides at least two photodiodes per colour may be omitted such that only a single photodiode per colour is provided although such an arrangement is less robust as there is no redundancy.

A particular advantage of providing not only colour filters but also one or more clear filters C or filterless optical paths is that the spectral sensor does not require a separate reference signal from a separate optical detector positioned elsewhere in or near the optical paths in the assay reader device. This reduces the complexity of the device and thus manufacturing cost. Further, as the photodiodes of the clear channel may be formed in the same substrate as part of the same die in the same process, all the photodiodes are likely to have the same temperature and other operating condition variations (e.g. any drift caused by changes in temperature is likely to be identical for all of the photodiodes so can be compensated for more easily). In contrast, when a reference signal is obtained from a separate optical detector, operating condition variations will not be the same as that of the spectral sensor so it is more difficult to compensate for such variations,

As described above in connection with Figures 4 and 5, the spectral sensor may be integrated into or onto the same substrate as the electrical signal processor. Figure 18 illustratively shows a functional block diagram of spectral sensor and electrical signal processor circuitry 1800 that may be used in connection with any of Figures 1-17. The circuitry 1800 may include a one or more of the following pins: positive supply terminal (VDD), ground (PGND and GND), serial interface clock signal line (SCL), serial interface data signal line (SDA), interrupt (INT), general purpose input/output (GPIO), and/or LED current sink input (LDR) to provide an interface between the photodiodes of the spectral sensor 1801 and the other components of the electrical signal processor such as, for example, a microcontroller unit (MCU). Signal processing may be provided through an I²C serial communication bus as will be appreciated by the skilled person. As will also be appreciated by the skilled person, a power supply and/or any additional resistors, capacitors and or other electronic components may also be provided. The electrical signal processor may further comprise one or more multiplexers and analogue to digital converters to optionally multiplex and subsequently convert analogue signals output by the photodiodes of the spectral sensor to a digital signal in corresponding data channels that may be output, for example through the serial interface data signal line (SDA) for further processing and ultimately reading of the intensity of a colour change and/or making a fluorescence measurement of the assay test region.

Advantageously, by providing the spectral sensor and electrical signal processor in an integrated manner as illustrated in Figures 17 and 18, the need for such components and circuitry to be provided as separate components on, for example, a PCB of an assay reader device is overcome. The assay reader device design is simplified because all components used to provide the spectral sensing functionality are provided as part of a single optical module that can be mounted to the assay reader device PCB in a single step, thus reducing the time taken and complexity of the assembly process of the assay reader device once the optical module itself has been assembled.

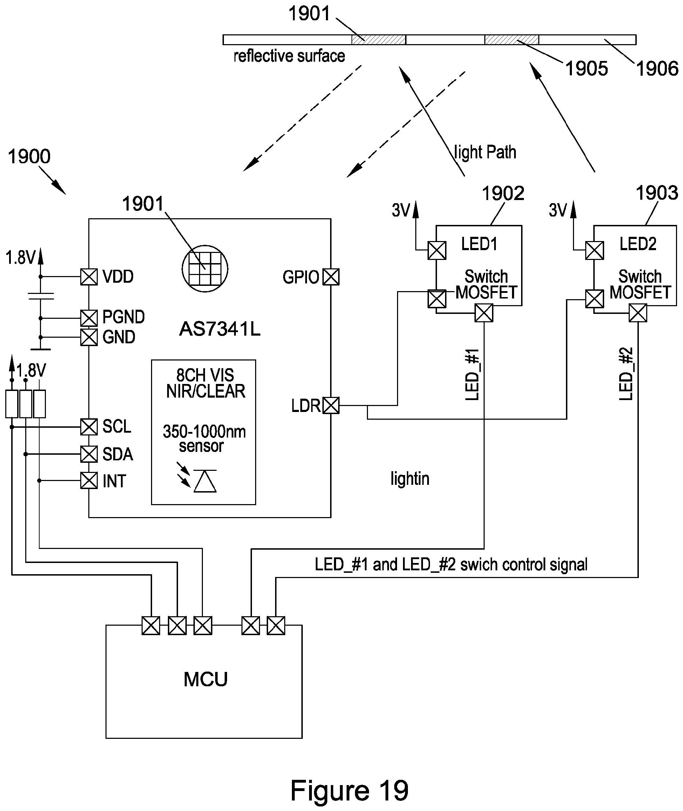

Figure 19 illustratively shows a functional block diagram such as that shown in Figure 18 applied to the example of reading a lateral flow test according to the present disclosure such as what is described in connection with Figures 1-16. The spectral sensor 1901 and electrical signal processor may be integrated into or onto the same substrate and may comprise circuitry 1900 such as that which is shown in Figure 18 including positive supply terminal (VDD), ground (PGND and GND), serial interface clock signal line (SCL), serial interface data signal line (SDA), interrupt (INT), general purpose input/output (GPIO), and/or LED current sink input (LDR) pins to provide an interface between the photodiodes of the spectral sensor 1801 and the other components of the electrical signal processor such as a microcontroller unit (MCU). Signal processing may be provided through an I²C serial communication bus as will be appreciated by the skilled person. As will also be appreciated by the skilled person, a power supply and/or any additional resistors, capacitors and or other electronic components may also be provided. In the example of Figure 19, two light sources 1902, 1903, this example LEDs, are also provided to illuminate test regions 1904, 1905 of a lateral flow test strip 1906. The light sources 1902, 1903 may be connected to the electrical signal processor and their respective outputs may be controlled and driven by the electrical signal processor. This may be advantageous where, for example, synchronisation between illumination and sensing is required for fluorescence measurements.

As illustrated in Figure 19, light from the light sources 1902, 1903 reflects from the test regions 1904, 1905 and is detected by the spectral sensor 1901. The respective output channels of the spectral sensor 1901 output the signal intensities of different wavelengths of the reflected light as determined by the colours of the filters of the spectral sensor 1901. In this way, a plurality of different colour changes in each of the test regions can be read simultaneously.

As described above, the one or more light sources described herein in connection with all of Figures 1-19 may each comprise an LED configured to emit electromagnetic energy over a broad range of the electromagnetic spectrum. For example, each LED may be configured to emit white light. However, it is envisaged that any colour of light may be used as determined by the requirements of the label particles the assay being imaged. In the case of a fluorescence measurement, the output signal of the LEDs may comprise a pulsed output controlled by the electrical signal processor and synchronised with the spectral sensor to perform a time-gated measurement.

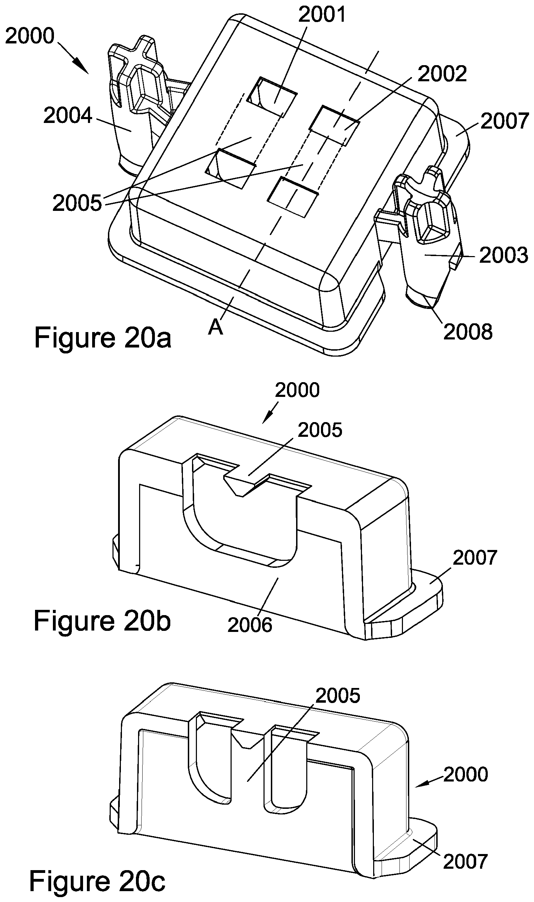

A different embodiment will now be described with reference to Figures 20a-24c that may be used with the optical modules described with reference to Figures 1-10.

Figure 20a shows a top view of an optical module housing 2000 according to the present disclosure. As with the optical modules of Figures 1-10, the housing 2000 defines a first opening 2001 and a second opening 2002 to provide an optical path from a one or more light sources to the respective test and/or control regions of an assay and to the optical detector. The housing 2000 in Figure 20a may also optionally be provided with one or more legs 2003, 2004 extending from a first and/or second outer surface of the housing 2000 in a vertical direction. In this case, the legs 2003, 2004 extend above and below the housing. In addition, the housing 2000 in Figure 20a also comprises a blocking portion 2005 configured to block a portion of light incident on or reflected by the test region to reduce an intensity of the light received by the optical detector of the optical module. The blocking portion 2005 serves the purpose of introducing a blind spot in the optical path to prevent specular reflections of the light emitted by the light source from reaching the optical detector. Specular reflections can be particularly intense from the materials of which lateral flow test strips are manufactured, such as nitrocellulose and/or wetted surfaces, and can easily saturate the optical detector, reducing the signal to noise ratio and prevent an accurate reading from being made. Specular reflections are particularly intense in the central region around the optical axis of the optical path between the light source and the optical detector where the beam emitted by the light source is strongest. By providing a blocking portion 2005, for example covering the central part of the optical path around the optical axis, a significant portion of the specular reflections are blocked and do not reach the optical detector. The portions of the openings 2001, 2002 that are not blocked allow reflections from the test/control regions where specular reflections are less intense to reach the optical detector, thereby providing a higher signal to noise ratio and increasing performance of the optical module. It is envisaged that this increase in performance may be provided for colourimetric as well as fluorescence type measurements.

The example blocking portion 2005 in Figure 20a is provided as an integral strip or tape across the opening 2001, 2002 defined by the housing 2000. The blocking portion 2005 may also be provided on any of the optical module housings described with reference to Figures 1-10.

Figure 20b shows a cross-sectional view of the housing 2000 of Figure 20a through line A-A. The blocking portion 2005 that cuts across the opening 2001, 2002 is shown to be integral with the housing 2000. One of the one or more baffles 2006 described above with reference to Figures 1-10 is also shown in Figure 20b. Whilst not shown in Figures 20a or 20b, a shaped surface to provide the above-described positional alignment may also be provided in the walls of the housing 2000 and a substrate that is additional to a printed circuit board of an assay reader device may also be provided to close the housing before it is placed onto a printed circuit board of an assay reader device. The housing 2100 shown in Figures 20a-20c may also be provided with a flange or step 2007 around at least a portion of its outer wall. The flange or step provides a larger area or overlap with an adjacent surface, for example a printed circuit board of an assay reader device.

A possible issue with the housing 2000 of Figures 20a and 20b is that a blocking portion 2005 when formed as an integral tape or strip across the openings 2001, 2002 cannot be manufactured easily in mold tools because the tape or strip prevents the housing from being removed easily from the mold. As a result, such a housing is difficult to mass produce cheaply. To overcome this problem, the blocking portion 2005 may instead be formed as a vertical pillar extending between an inside surface of the housing 2000 and the one or more baffles 2006. Such an arrangement is shown in Figure 20c.

However, whilst the arrangement of Figure 20c may be more easily injection molded and accordingly be suitable for cheap mass production, the vertical pillar between an inside surface of the housing 2000 and the one or more baffles 2006 was found to cause a reduced performance. This is in part because the position of the baffle and/or openings needed to be adjusted away from the optimum position with the highest signal to noise ratio to allow the vertical pillar to be joined there between.

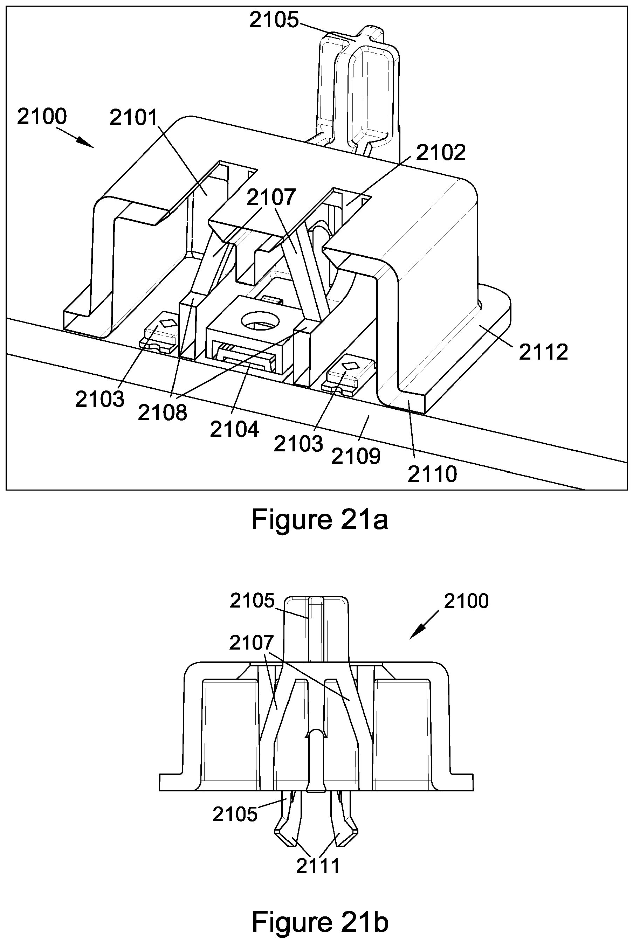

An arrangement that overcomes the above described reduced performance of Figure 20c while retaining the ability to block specular reflections and be mass produced cheaply with injection molding will now be described with reference to the arrangement provided in Figures 21a-23c.

Figure 21a similarly shows a cross-sectional view of a housing 2100 according to the present disclosure. As with the optical modules of Figures 1-10 and 20a-20c, the housing 2100 defines a first opening 2101 and a second opening 2102 to provide an optical path from light sources 2103 to the respective test and/or control regions of an assay and to the optical detector 2104, such as that shown in Figured 4 and 5. The housing 2100 in Figure 21a comprises legs 2105 extending from a first and/or second outer surface of the housing 2100 in a vertical direction. Baffles 2107 are also shown in Figure 21a. Legs 2105 provided in Figure 21 extend both above and below the upper and lower surfaces of the housing 2100. A substrate 2109 is illustrated in Fig. 21a. The substrate may be a printed circuit board of an assay reader device on which the optical detector 2104 and light sources 2103 are mounted. A flange or step shape in the wall of the housing 2100 is provided for an increased overlap area when the housing is positioned on the substrate 2109. Whilst not shown in Figure 21a, a substrate that is additional to the printed circuit board of an assay reader device may also be provided to close the housing before it is placed onto a printed circuit board of an assay reader device as is described, for example, in Figures 1-10.

In embodiments in accordance with the invention, angled pillars 2107 extend from an inside surface of the housing 2100 between the first and second openings 2101, 2102 to the baffles 2108. The angle allows the baffles 2108 and openings 2101, 2102 to be positioned at an optimum position where signal to noise ratio is highest, for example at least partially directly under the openings 2101, 2102, while still blocking a portion of the light in which the specular reflections are strongest. In this way, the reduced performance of Figures 20a-20c is overcome in a way that allows mass production by injection molding.

Figure 21b shows a cross-sectional view of the housing 2100 of Figure 21a. Also visible in Figure 21b is the extent of the legs 2105 which extend above and below the upper and lower surfaces of the housing 2100.

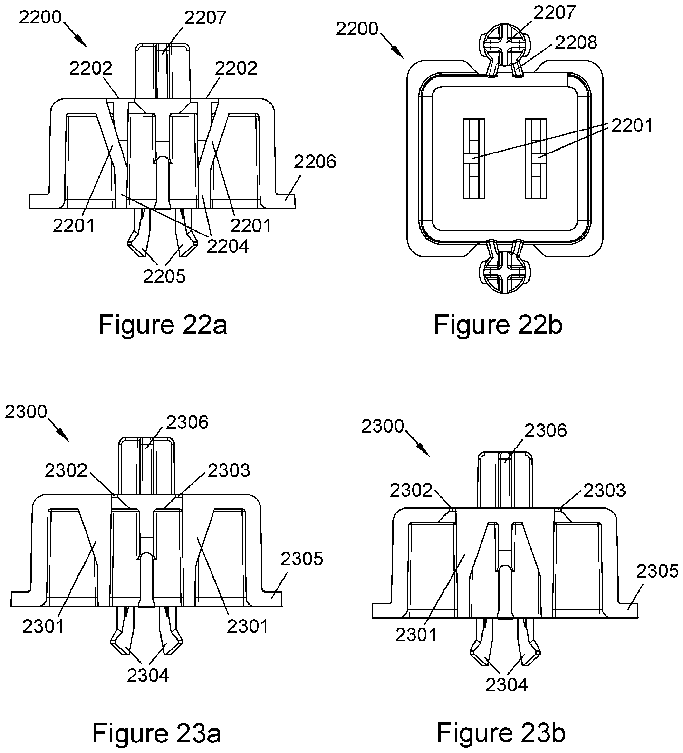

Figure 22a shows a cross-sectional view of a variation of the housing of Figures 21a-21b. The housing 2200 of Figure 22a is generally the same as housing 2100 of Figures 21-21b except that the blocking portion 2201 extends not from the portion of the housing between the openings 2202, 2203 to the one or more baffles 2204 but instead extends from the portion of the housing outside of the openings at a non-90 degree angle inwards to the baffles 2204. While in Figures 21a-21b a portion of the light reflected from the test region is blocked to reduce specular reflections, the blocking portion 2201 in Figure 22a blocks light incident on the test region, thereby preventing intense specular reflections from occurring in the first place.

Figure 22b shows a top view of the housing 2200 of Figure 22a. The blocking portion 2201 in the form of an angled pillar is visible in Figure 22b.

Figures 23a and 23b show cross-sectional views of further alternatives to the housings of Figures 21a-21b and 22a-22b. In particular, the housings 2300 of Figures 23a and 23b are generally that same as those of 21a-21b and 22a-22b respectively except that the blocking portion 2301 is formed as an angled pillar that widens as it extends away from the one or more baffles to the inside, upper surface of the housing. The increase of thickness is in the direction of the outside of the openings 2302, 2303 in the case of Figure 23a and in the direction of the housing portion between the openings 2302, 2303 in the case of Figure 23b.

As is shown in all of Figures 20a-23b, the legs of the housing may extend from a first and/or second outer surface of the housing in a vertical direction which may include an extension both above and below the height of the housing. One or more of the legs may comprise a flexible hook portion 2008, 2111, 2205, 2304. The flexible hook portion is configured to secure the housing to the substrate. The housing is positioned with a snap-fit engagement (for example a cantilever, annular or torsional snap-fit engagement) through one or more respective holes in the substrate. The snap-fit engagement provides a tight enough engagement to prevent relative movement between the substrate and the housing without the need to use glue or other less accurate securing means such as solder that may suffer from reflow and/or may be difficult to control the thickness of. The optional flange or step portion 2007, 2112, 2206, 2305 of the housing ensures the force generated by the flexible hook portion 2008, 2111, 2205, 2304 to evenly spread on the surface of the substrate.

Further, where the one or more legs 2004, 2105, 2207, 2306 extend vertically beyond the housing in the opposite direction to the substrate, for example above the height of the openings in the housing, the legs may be configured for mating engagement with one or more respective holes in a housing of an assay reader device. In this way, the part of the legs that extend beyond the housing in the direction of the substrate may engage with the substrate and the part of the legs that extend in the direction beyond the housing in the opposite direction may engage with a housing of an assay reader device. This arrangement ensures the optical module housing is aligned not only with the printed circuit board of an assay reader device but also with the housing of the assay reader device itself.

In the optical module housings of Figures 20a-23b, the one or more legs 2004, 2105, 2207, 2306 are positioned offset from the walls of the housing. This may be achieved through the use of one or more arms 2208 shown in Figure 22b. Alternatively, the legs are positioned at the corners of the housing as illustrated in Figures 1-10.

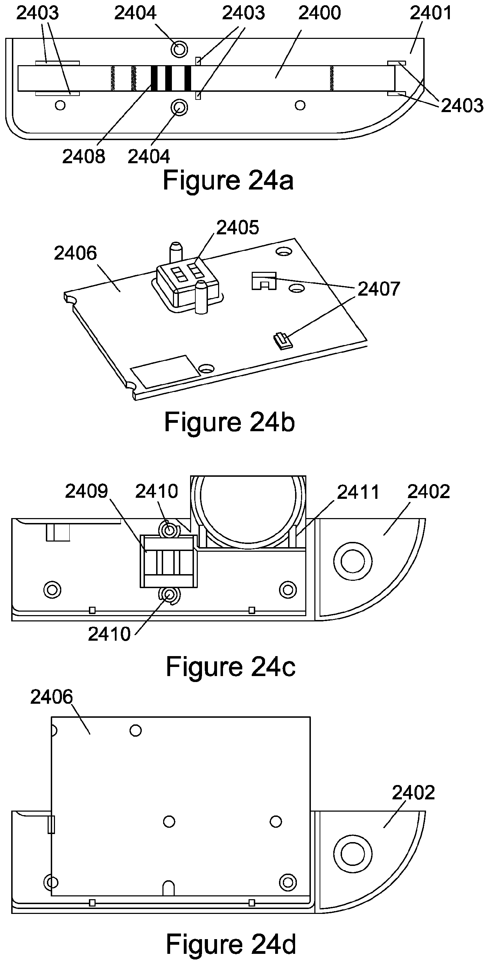

Figures 24a-24d illustratively show various views of stages of assembly of an assay reader device 2400 according to the present disclosure.

In Figure 24a, a lateral flow test strip 2400 is positioned in a first part of an assay reader housing 2401 in a similar manner to what is described with reference to Figures 15a-15d. As in Figures 15a-15d, the housing 2401 comprises a plurality of component parts including an outer shell (made up of one or more parts) and internal support structures and/or intermediate support layers 2402 that are injection moulded or 3D printed parts. The lateral flow test strip is positioned with one or more support structures or spacers 2403 of the first part of the assay reader housing 2401 in alignment with one or more optical module mounting structures 2404 (for example one or more slots) of the housing 2401 configured to receive the one or more legs of the optical module housing as will be described below. The one or more support structures or spacers 2403 may have a height and position configured to cause the lateral flow test strip to become taut and or tensioned over the support structures or spacers when the assay reader device is assembled in the same way as is described with reference to Figure 15e. It is envisaged that the lateral flow test strip 2400 is placed into the first part of the assay reader housing 2401 with a pick and place machine with a tolerance of around ±10µm in the XY direction (i.e. the plane of the test strip) and around ±3µm in the Z direction (i.e. perpendicular to the test strip).

In Figure 24b, an optical module housing 2405 such as is described in Figures 20a-23b is mounted to a substrate 2406. In the example of Figure 24b, the substrate 2406 is also the printed circuit board of the assay reader device. Accordingly, the optical module housing 2405 is positioned over the one or more light sources and optical detector already mounted on the substrate 2406. As described above with reference to Figures 20a-23b, the one or more legs 2004, 2105, 2207, 2306 are configured to secure the optical module housing to the substrate with a snap-fit engagement through one or more respective holes in the substrate, thereby preventing relative movement between the substrate and the housing without the need to use glue or, for example a screw, which can be difficult to control and risks misalignment of the light sources and optical detector relative to the openings in the optical module housing. In the example of Figures 24a-24b, the substrate 2406 is provided with battery contacts 2407. Other electronic and circuitry components may also be provided on the substrate 2406 as will be appreciated by the skilled person.

In Figure 24c, an intermediate support layer 2402 of the housing 2401 is positioned onto the first part of the housing 2401 after the lateral flow test strip 2400 has been mounted. The intermediate support layer 2402 covers the majority of the lateral flow test strip 2400 except for a portion of the test strip with the test and/or control regions. The test and/or control regions are visible through a gap 2409. The lateral flow test strip 2400 is accordingly held down onto the support structures or spacers 2403 by the intermediate support layer 2402 to ensure the Z position of the test and/or control regions is controlled up to a degree of tolerance of around ±3µm. This is be achieved in the manner described, for example, in Figure 15e. To achieve the desired XY position tolerance, the test strip is provided with an alignment line 2408. The edge of the line is used to position a corresponding edge of the gap 2409 and the position of the optical module mounting structures 2404 aligns with corresponding holes 2410 in the intermediate support layer 2402 which holes in turn are positioned half way between the test and/or control regions.

Accordingly, if the first part of the housing 2401 and the intermediate support layer 2402 are not aligned, the holes 2410 do not match up and the optical module housing legs cannot be inserted through the intermediate support layer 2402 and into the optical module mounting structures 2404. Thus, the assay reader device cannot be fully assembled unless the intermediate support layer 2402 and first part of the housing 2401 (and thus lateral flow test strip mounted there) are also aligned. The intermediate support layer 2402 may also be provided with a battery retaining portion 2411 in which a battery may be positioned.

In Figure 24d, the substrate 2406 is placed onto the intermediate support layer 2402. The one or more extending legs of the optical module housing 2405 are aligned with the optical module support structures 2404 in the first part of the housing 2401 through the corresponding holes in the intermediate support layer 2402. Finally, a second part of the assay reader device housing (not shown) may be used to close the assay reader device to provide the assembled device.

The optical module housing and in particular the position of its openings is aligned with respect to the test and/or control regions of the lateral test strip to the desired degree of tolerance. The use of alignment pins or structures, which are not integral with the optical module housing, is avoided. Examples of alignment pins or structures which are not integral are screws and or holes on the printed circuit board.

Although the invention has been described in terms of preferred embodiments as set forth above, it should be understood that these embodiments are illustrative only and that the claims are not limited to those embodiments. Those skilled in the art will be able to make modifications and alternatives in view of the disclosure which are contemplated as falling within the scope of the appended claims. Each feature disclosed or illustrated in the present specification may be incorporated in the invention, whether alone or in any appropriate combination with any other feature disclosed or illustrated herein.

## Claims

1. An optical module (100) for reading a test region of an assay, the optical module comprising:
• a first light source (101) for illuminating the test region of the assay;
• an optical detector (103), comprising an optical input for receiving light emitted from the test region of the assay and an electrical output;
• a substrate (104) for mounting the first light source (101) and the optical detector (103);
• a housing (105) defining a first opening (106) for providing a first optical path from the first light source (101) to the test region and from the test region to the optical detector (103);
∘ wherein the housing (105) and the substrate (104) enclose and positionally align the first light source (101) and the optical detector (103) relative to the first opening (106);
• a second light source (102) for illuminating a control region of the assay;
∘ wherein the second light source (102) is mounted on the substrate (104),
∘ wherein the housing (105) comprises a second opening (107) for providing a second optical path from the second light source (102) to the control region and from the control region to the optical detector (103), and
∘ wherein the housing (105) and the substrate (104) further enclose and positionally align the second light source (102) relative to the first and second openings (106, 107), and the optical detector (103);
• one or more first baffles (110) positioned on the substrate (104) between the optical detector (103) and the first light source (101) to block direct propagation of light from the first light source (101) to the optical detector (103);
**characterized in that** the optical module (100) further comprises angled pillars (2107) extending from an inside surface of the housing (105) between the first and second openings (106, 107) to the first baffles (110), wherein the angled pillars (2107) are positioned at an optimum position where signal to noise ratio is highest.

2. The optical module (100) of claim 1, wherein one or more walls of the housing (105) comprise a shaped surface (109) configured to receive the substrate (104) in a predetermined position to provide positional alignment.

3. The optical module (100) of claim 2, wherein the shaped surface (109) comprises one or more of a step, slot, and/or bevel on one or more surfaces of said walls of the housing (105).

4. The optical module (100) of any preceding claim, wherein the housing (105) comprises one or more legs (108) extending from a first and/or second outer surface of the housing (105) in a vertical direction.

5. The optical module (100) of claim 4, wherein one or more of the one or more legs (108) comprises a flexible hook portion.

6. The optical module (100) of claim 5, wherein the flexible hook portion is configured to secure the housing (105) to the substrate (104) with a snap-fit engagement through one or more respective holes in the substrate (104) preventing relative movement between the substrate (104) and the housing (105).

7. The optical module (100) of claim 5, wherein the one or more legs (108) are configured for mating engagement with one or more respective holes in a printed circuit board of an assay reader device to positionally align the optical module (100) relative to the printed circuit board of the assay reader device.

8. The optical module (100) of any preceding claim comprising:
a blocking portion (2005) positioned in the first optical path configured to block a portion of light incident on or reflected by the test region to reduce an intensity of the light received by the optical detector (103).

9. The optical module (100) of claim 8, wherein the blocking portion (2005) is positioned between an inside surface of the housing (105) and the one or more first baffles (110) and blocks a central portion of the optical axis of the first optical path.

10. The optical module (100) of any preceding claim, comprising: one or more second baffles (111) positioned on an inside surface of the housing (105) between the first and second openings (106, 107) to block propagation of light from the first light source (101) to the control region and to block propagation of light from the second light source (102) to the test region.

11. The optical module (100) of any preceding claim,
wherein the first and second light sources (101, 102), and/or the optical detector (103) are encased in a moulded polymer compound (407a), and
wherein the first and second optical paths are provided through the moulded polymer compound (407a).

12. The optical module (100) of any of any preceding claim, wherein a portion (901) of the housing (105) comprises a transparent material having an opaque material (902) on a surface thereof, and wherein the first and/or the second openings comprise gaps (903, 904) in the opaque material (902).

13. The optical module (100) of any preceding claim, wherein the first light source (101) the optical detector (103) and the second light source (102), and/or where present an electrical signal processor, electrically coupled to the electrical output of the optical detector (103), are provided adjacent to one another in a first planar arrangement, wherein the first and the second openings (106, 107) are provided in a second planar arrangement parallel to and facing the first planar arrangement.

14. An assay reader device (1000) comprising the optical module (100) of any of claims 1-13.

## Patentansprüche

1. Optisches Modul (100) zum Lesen einer Testregion eines Assays, wobei das optische Modul umfasst:
• eine erste Lichtquelle (101) zum Beleuchten der Testregion des Assays;
• einen optischen Detektor (103), der einen optischen Eingang zum Empfangen von Licht, das von der Testregion des Assays emittiert wird, und einen elektrischen Ausgang umfasst;
• ein Substrat (104) zum Montieren der ersten Lichtquelle (101) und des optischen Detektors (103);
• ein Gehäuse (105), das eine erste Öffnung (106) zum Bereitstellen eines ersten optischen Pfads von der ersten Lichtquelle (101) zu der Testregion und von der Testregion zu dem optischen Detektor (103) definiert;
o wobei das Gehäuse (105) und das Substrat (104) die erste Lichtquelle (101) und den optischen Detektor (103) relativ zu der ersten Öffnung (106) umschließen und in ihrer Position ausrichten;
• eine zweite Lichtquelle (102) zum Beleuchten einer Steuerregion des Assays;
o wobei die zweite Lichtquelle (102) auf dem Substrat (104) montiert ist,
o wobei das Gehäuse (105) eine zweite Öffnung (107) zum Bereitstellen eines zweiten optischen Pfads von der zweiten Lichtquelle (102) zu der Steuerregion und von der Steuerregion zu dem optischen Detektor (103) umfasst, und
o wobei das Gehäuse (105) und das Substrat (104) weiter die zweite Lichtquelle (102) relativ zu der ersten und zweiten Öffnung (106, 107) und dem optischen Detektor (103) umschließen und in ihrer Position ausrichten;
• ein oder mehrere erste Leitbleche (110), die auf dem Substrat (104) zwischen dem optischen Detektor (103) und der ersten Lichtquelle (101) positioniert sind, um direkte Ausbreitung von Licht von der ersten Lichtquelle (101) zu dem optischen Detektor (103) zu blockieren;
**dadurch gekennzeichnet, dass** das optische Modul (100) weiter angewinkelte Säulen (2107) umfasst, die sich von einer Innenfläche des Gehäuses (105) zwischen der ersten und zweiten Öffnung (106, 107) zu den ersten Leitblechen (110) erstrecken, wobei die angewinkelten Säulen (2107) an einer optimalen Position positioniert sind, wo Signal/Rauschen-Verhältnis am höchsten ist.

2. Optisches Modul (100) nach Anspruch 1, wobei eine Wand oder mehrere Wände des Gehäuses (105) eine geformte Oberfläche (109) umfassen, die eingerichtet ist, das Substrat (104) in einer vorbestimmten Position aufzunehmen, um Positionsausrichtung bereitzustellen.

3. Optisches Modul (100) nach Anspruch 2, wobei die geformte Oberfläche (109) eines oder mehrere von einer Stufe, einem Schlitz und/oder einer Abschrägung an einer oder mehreren Oberflächen der Wände des Gehäuses (105) umfasst.

4. Optisches Modul (100) nach einem vorstehenden Anspruch, wobei das Gehäuse (105) einen oder mehrere Schenkel (108) umfasst, die sich von einer ersten und/oder zweiten Außenfläche des Gehäuses (105) in einer vertikalen Richtung erstrecken.

5. Optisches Modul (100) nach Anspruch 4, wobei einer oder mehrere des einen oder der mehreren Schenkel (108) einen flexiblen Hakenteil umfassen.

6. Optisches Modul (100) nach Anspruch 5, wobei der flexible Hakenteil eingerichtet ist, das Gehäuse (105) an dem Substrat (104) mit einem Schnappeingriff durch ein entsprechendes Loch oder mehrere entsprechende Löcher in dem Substrat (104) zu befestigen, wodurch relative Bewegung zwischen dem Substrat (104) und dem Gehäuse (105) verhindert wird.

7. Optisches Modul (100) nach Anspruch 5, wobei der eine oder die mehreren Schenkel (108) für einen passenden Eingriff mit einem entsprechenden Loch oder mehreren entsprechenden Löchern in einer Leiterplatte einer Assay-Lesevorrichtung eingerichtet sind, um eine Position des optischen Moduls (100) relativ zu der Leiterplatte der Assay-Lesevorrichtung auszurichten.

8. Optisches Modul (100) nach einem vorstehenden Anspruch, umfassend:
einen Blockierungsteil (2005), der in dem ersten optischen Pfad positioniert ist, der eingerichtet ist, einen Teil von Licht, das auf die Testregion einfällt oder von ihr reflektiert wird, zu blockieren, um eine Intensität des Lichts zu verringern, das von dem optischen Detektor (103) empfangen wird.

9. Optisches Modul (100) nach Anspruch 8, wobei der Blockierungsteil (2005) zwischen einer Innenfläche des Gehäuses (105) und dem einen oder den mehreren Leitblechen (110) positioniert ist und einen zentralen Teil der optischen Achse des ersten optischen Pfads blockiert.

10. Optisches Modul (100) nach einem vorstehenden Anspruch, umfassend:
ein oder mehrere Leitbleche (111), die an einer Innenfläche des Gehäuses (105) zwischen der ersten und zweiten Öffnung (106, 107) angeordnet sind, um Ausbreitung von Licht von der ersten Lichtquelle (101) zu der Steuerregion zu blockieren und Ausbreitung von Licht von der zweiten Lichtquelle (102) zu der Testregion zu blockieren.

11. Optisches Modul (100) nach einem vorstehenden Anspruch,
wobei die erste und zweite Lichtquelle (101, 102) und/oder der optische Detektor (103) in einer geformten Polymerverbindung (407a) eingehüllt sind; und
wobei der erste und zweite optische Pfad durch die geformte Polymerverbindung (407a) bereitgestellt sind.

12. Optisches Modul (100) nach einem vorstehenden Anspruch, wobei ein Teil (901) des Gehäuses (105) ein transparentes Material mit einem undurchsichtigen Material (902) auf seiner Oberfläche umfasst und wobei die erste und/oder die zweite Öffnung Spalte (903, 904) in dem undurchsichtigen Material (902) umfasst.

13. Optisches Modul (100) nach einem vorstehenden Anspruch, wobei die erste Lichtquelle (101) des optischen Detektors (103) und die zweite Lichtquelle (102) und/oder, wenn vorhanden, ein elektrischer Signalprozessor, der elektrisch an den elektrischen Ausgang des optischen Detektors (103) gekoppelt ist, nebeneinander in einer ersten planaren Anordnung bereitgestellt sind, wobei die erste und die zweite Öffnung (106, 107) in einer zweiten planaren Anordnung parallel zu der ersten planaren Anordnung und dieser zugewandt bereitgestellt sind.

14. Assay-Lesevorrichtung (1000), die das optische Modul (100) nach einem der Ansprüche 1-13 umfasst.

## Revendications

1. Module optique (100) pour lire une région de test d'une analyse, le module optique comprenant :
• une première source lumineuse (101) pour illuminer la région de test de l'analyse ;
• un détecteur optique (103) comprenant une entrée optique pour recevoir la lumière émise depuis la région de test de l'analyse et une sortie électrique ;
• un substrat (104) pour le montage de la première source lumineuse (101) et du détecteur optique (103) ;
• un boîtier (105) définissant une première ouverture (106) pour fournir un premier trajet optique de la première source lumineuse (101) à la région de test et de la région de test au détecteur optique (103) ;
o dans lequel le boîtier (105) et le substrat (104) renferment et alignent positionnellement la première source lumineuse (101) et le détecteur optique (103) par rapport à la première ouverture (106) ;
• une deuxième source lumineuse (102) pour illuminer une région de commande de l'analyse ;
o dans lequel la deuxième source lumineuse (102) est montée sur le substrat (104),
o dans lequel le boîtier (105) comprend une deuxième ouverture (107) pour fournir un deuxième trajet optique de la deuxième source lumineuse (102) à la région de commande et de la région de commande au détecteur optique (103) et
o dans lequel le boîtier (105) et le substrat (104) renferment en outre et alignent positionnellement la deuxième source lumineuse (102) par rapport à la première et la deuxième ouvertures (106, 107) et au détecteur optique (103) ;
• un ou des premiers déflecteurs (110) positionnés sur le substrat (104) entre le détecteur optique (103) et la première source lumineuse (101) pour bloquer une propagation de lumière directe de la première source lumineuse (101) au détecteur optique (103) ;
**caractérisé en ce que** le module optique (100) comprend en outre des piliers inclinés (2107) s'étendant d'une surface intérieure du boîtier (105) entre la première et deuxième ouvertures (106, 107) vers les premiers déflecteurs (110), dans lequel les piliers inclinés (2107) sont positionnés à une position optimale où le rapport signal sur bruit est le plus haut.

2. Module optique (100) selon la revendication 1, dans lequel une ou des parois du boîtier (105) comprennent une surface façonnée (109) configurée pour recevoir le substrat (104) dans une position prédéterminée afin de fournir un alignement positionnel.

3. Module optique (100) selon la revendication 2, dans lequel la surface façonnée (109) comprend un ou plusieurs d'un gradin, une fente et/ou un chanfrein sur une ou des surfaces desdites parois du boîtier (105) .

4. Module optique (100) selon une quelconque des revendications précédentes, dans lequel le boîtier (105) comprend un ou des pieds (108) s'étendant depuis une première et/ou une deuxième surface extérieure du boîtier (105) dans une direction verticale.

5. Module optique (100) selon la revendication 4, dans lequel un ou plusieurs de un ou plusieurs pieds (108) comprennent une partie de crochet flexible.

6. Module optique (100) selon la revendication 5, dans lequel la partie de crochet flexible est configurée pour fixer le boîtier (105) au substrat (104) avec une mise en prise par encliquetage à travers un ou plusieurs trous respectifs dans le substrat (104) en empêchant un mouvement relatif entre le substrat (104) et le boîtier (105).

7. Module optique (100) selon la revendication 5, dans lequel le ou les pieds (108) sont configurés pour une mise en prise par emboîtement avec un ou des trous respectifs dans une plaquette de circuit imprimé d'un dispositif lecteur d'analyse pour aligner positionnellement le module optique (100) par rapport à la plaquette de circuit imprimé du dispositif lecteur d'analyse.

8. Module optique (100) selon une quelconque des revendications précédentes, comprenant :
une partie de blocage (2005) positionnée dans le premier trajet optique configurée pour bloquer une partie de lumière incidente sur ou réfléchie par la région de test afin de réduire une intensité de la lumière reçue par le détecteur optique (103).

9. Module optique (100) selon la revendication 8, dans lequel la partie de blocage (2005) est positionnée entre une surface intérieure du boîtier (105) et un ou des premiers déflecteurs (110) et bloque une partie centrale de l'axe optique du premier trajet optique.

10. Module optique (100) selon une des revendications précédentes, comprenant
un ou des deuxièmes réflecteurs (111) positionnés sur une surface intérieure du boîtier (105) entre la première et deuxième ouvertures (106, 107) pour bloquer la propagation de lumière de la première source lumineuse (101) à la région de commande et bloquer la propagation de lumière de la deuxième source lumineuse (102) à la région de test.

11. Module optique (100) selon une des revendications précédentes,
dans lequel la première et deuxième sources lumineuses (101, 102) et/ou la détecteur optique (103) sont encastrés dans un composé polymère moulé (407a) et
dans lequel le premier et deuxième trajets optiques sont prévus à travers le composé polymère moulé (407a) .

12. Module optique (100) selon une quelconque des revendications précédentes, dans lequel une partie (901) du boîtier (105) comprend un matériau transparent ayant un matériau opaque (902) sur une surface de ce dernier et dans lequel la première et/ou la deuxième ouvertures comprennent des interstices (903, 904) dans le matériau opaque (902).

13. Module optique (100) selon une quelconque des revendications précédentes, dans lequel la première source lumineuse (101), le détecteur optique(103) et la deuxième source lumineuse (102) et/ou le cas échéant un processeur de signal électrique, couplé électriquement à la sortie électrique du détecteur optique (103) sont prévus en juxtaposition les uns aux autres dans un agencement planaire, dans lequel la première et deuxième ouvertures (106, 107) sont prévues dans un deuxième agencement planaire parallèle à et faisant face au premier agencement planaire.

14. Dispositif de lecteur d'analyse (1000) comprenant le module optique (100) selon une des revendications 1-13.
